# EUROPEAN PATENT APPLICATION

(11) **EP 4 550 428 A1**
(43) Date of publication of application: **07.05.2025**
(21) Application number: 22950919.5
(22) Date of filing: 23.11.2022
(51) Int. Cl.: H01L 33/38, H01L 33/50, H01L 25/075, H01L 25/16, H01L 33/00, H01L 33/08, H01L 33/62, H01L 27/15

(54) **PIXEL UNIT AND MANUFACTURING METHOD THEREFOR, MICRO DISPLAY SCREEN, AND PIXEL-LEVEL DISCRETE DEVICE**

(30) Priority: 12.07.2022 CN 202210812558; 12.07.2022 CN 202210812459
(71) Applicant: Nuoshi Technology (Suzhou) Co., Ltd., Suzhou, Jiangsu 215000 (CN)
(72) Inventor: WANG, Yazhou, Suzhou, Jiangsu 215000 (CN)
(74) Representative: Winter, Brandl - Partnerschaft mbB
(86) International application number: PCT/CN2022/133779
(87) International publication number: WO 2024/011811

(57) **Abstract**

This application provides a pixel unit, a manufacturing method therefor, a microdisplay, and a pixel-level discrete device. The pixel unit includes a backplane and a display unit. The display unit is arranged on the backplane, and includes a first device layer and a second device layer vertically stacked sequentially in a direction away from the backplane. The first device layer includes a first compound light-emitting layer and a second compound light-emitting layer adjacent to each other. The second device layer includes a color conversion layer and a third compound light-emitting layer adjacent to each other. The color conversion layer is arranged above the first compound light-emitting layer. According to this application, the color conversion layer is arranged, so that the compound whose external quantum efficiency is greatly decreased can implement color development through color conversion, to reduce power and improve performance. **In** addition, the pixel unit occupies less space in the horizontal direction. Compared with a pixel unit arranged in the horizontal direction, pixel density is less limited. Moreover, a decrease in external quantum efficiency caused by a size effect is effectively reduced, power consumption is effectively reduced, and performance such as brightness is improved, so that the yield can be effectively improved.

## Description

### TECHNICAL FIELD

This application relates to the field of semiconductor device technologies, and in particular, to a pixel unit, a manufacturing method therefor, a microdisplay, and a pixel-level discrete device.

### BACKGROUND

Micro-LED display technology is widely considered as a next-generation display technology, and has great prospects in both the field of wearable devices and the field of direct-view displays. Conventional red-emitting LEDs are based on an AlGaInP material system, and green- and blue-emitting LEDs are both based on an InGaN material system. Development of the two material systems has greatly promoted development of LED lighting, display backlight, and other applications. However, when conventional LEDs are directly used as display pixels and the LED size changes from the millimeter level to the micrometer level, especially when the LED size is 20 µm or lower, the decrease in external quantum efficiency (EQE) caused by the size effect affects power consumption and performance of Micro-LEDs, particularly red-emitting LEDs based on the AlGaInP system.

More importantly, the yield loss caused by the foregoing defects cannot be ignored, and as the device size is reduced for display purposes, high requirements are imposed on the yield of Micro-LEDs in the industry. It is learned that when the size is at the 15 µm/5 µm level, external quantum efficiency of Micro-LEDs (uLEDs) is much lower than that of LEDs (45%) and OLEDs (22%) of conventional sizes. Such a decrease in external quantum efficiency leads to insufficient brightness and energy loss, greatly limiting the development of microdisplay technologies.

Similarly, when the size of pixel-level discrete devices changes from the millimeter level to the micrometer level, especially when the size is 20 µm or lower, the decrease in external quantum efficiency caused by the size effect affects power consumption and performance of pixel-level discrete devices, particularly red-emitting LEDs based on the AlGaInP system.

Therefore, it is necessary to find a semiconductor device that can effectively overcome the foregoing defects.

### SUMMARY

An objective of this application is to provide a pixel unit, a manufacturing method therefor, a microdisplay, and a pixel-level discrete device, to effectively reduce impact of the size effect and effectively cope with the yield loss.

To achieve the objective of this application, according to a first aspect of this application, a pixel unit is provided, including:
a backplane; and
a display unit, where the display unit is arranged on the backplane, the display unit includes a first device layer and a second device layer vertically stacked sequentially in a direction away from the backplane, the first device layer includes a first compound light-emitting layer and a second compound light-emitting layer adjacent to each other, the second device layer includes a color conversion layer and a third compound light-emitting layer adjacent to each other, and the color conversion layer is arranged above the first compound light-emitting layer.

In a preferred implementation, the pixel unit further includes a common cathode, the common cathode is arranged around a periphery of the display unit, the common cathode is respectively connected to the first compound light-emitting layer, the second compound light-emitting layer, and the third compound light-emitting layer, and the common cathode is connected to an external cathode.

In a preferred implementation, the pixel unit further includes an enhanced common cathode, the enhanced common cathode and the common cathode are connected to enclose a first region and a second region separated from each other, the first compound light-emitting layer and the color conversion layer are stacked in the first region, and the second compound light-emitting layer and the third compound light-emitting layer are stacked in the second region.

In a preferred implementation, the first device layer further includes a first bonding layer, and the first bonding layer is made of an insulating material; and
the first bonding layer is attached onto the backplane, and the first compound light-emitting layer and the second compound light-emitting layer are respectively attached onto a side of the first bonding layer away from the backplane.

In a preferred implementation, the first device layer further includes a first anode electrical connection structure and a second anode electrical connection structure;
an end of the first anode electrical connection structure is connected to the first compound light-emitting layer, and an other end of the first anode electrical connection structure extends toward the backplane; and
an end of the second anode electrical connection structure is connected to the second compound light-emitting layer, and an other end of the second anode electrical connection structure extends toward the backplane.

In a preferred implementation, the first compound light-emitting layer includes a first P-type ohmic contact layer, a first compound semiconductor layer, and a first N-type ohmic contact layer sequentially attached, the first P-type ohmic contact layer is fittedly attached to the first bonding layer, and an area of the first P-type ohmic contact layer is larger than an area of the first compound semiconductor layer; and
the first anode electrical connection structure is arranged opposite to a side of the first compound semiconductor layer, and part of the first anode electrical connection structure passes through the first P-type ohmic contact layer and the first bonding layer sequentially.

In a preferred implementation, the common cathode includes a first cathode electrical connection structure, and the first cathode electrical connection structure is connected to the first N-type ohmic contact layer.

In a preferred implementation, the second device layer further includes a second bonding layer, and the second bonding layer is made of a transparent insulating material; and
the second bonding layer is attached onto the first device layer, and the color conversion layer and the third compound light-emitting layer are respectively attached onto a side of the second bonding layer away from the first device layer.

In a preferred implementation, the color conversion layer is attached onto the second bonding layer, and an area of a projection of the color conversion layer on the backplane is larger than an area of a projection of the first compound light-emitting layer on the backplane.

In a preferred implementation, a photochromic material is used in the color conversion layer, and a wavelength of a light source of the first compound semiconductor layer is less than a wavelength of light of the color conversion layer.

In a preferred implementation, at least one of a red light quantum dot material or a red phosphor material is used in the color conversion layer.

In a preferred implementation, the second device layer further includes a third anode electrical connection structure, the third anode electrical connection structure is arranged opposite to a side of the third compound semiconductor layer, an end of the third anode electrical connection structure is connected to the third compound light-emitting layer, and an other end of the third anode electrical connection structure extends toward the backplane.

In a preferred implementation, the display unit further includes a first insulating wrapping layer and a second insulating wrapping layer, and both the first insulating wrapping layer and the second insulating wrapping layer are made of a transparent insulating material;
the first insulating wrapping layer wraps the first compound light-emitting layer, the second compound light-emitting layer, the first anode electrical connection structure, the second anode electrical connection structure, part of the third anode electrical connection structure, and part of the common cathode; and
the second insulating wrapping layer wraps the color conversion layer, the third compound light-emitting layer, part of the third anode electrical connection structure, and part of the common cathode.

In a preferred implementation, the backplane is provided with a drive circuit, the drive circuit is provided with at least one anode, and the at least one anode includes a first anode, a second anode, and a third anode; and
the first anode electrical connection structure is connected to the first anode, the second anode electrical connection structure is connected to the second anode, and the third anode electrical connection structure is connected to the third anode.

In a preferred implementation, the display unit further includes a water vapor isolation layer arranged on a surface of the second device layer.

In a preferred implementation, the pixel unit further includes at least four pads, the at least four pads include a cathode pad and at least three anode pads, and at least part of any one of the at least four pads is embedded in the backplane;
the common cathode is connected to the cathode pad; and
the first anode electrical connection structure, the second anode electrical connection structure, and the third anode electrical connection structure are respectively connected to corresponding anode pads among the at least three anode pads.

In a preferred implementation, a device body is arranged separately from the backplane, and the at least four pads are arranged separately from the backplane; and
the pixel-level discrete device further includes an isolation support structure, and the isolation support structure covers the device body and is connected to the backplane.

In a preferred implementation, the isolation support structure includes a covering portion and a fixing portion connected to each other, the covering portion covers a device body, and the fixing portion is connected to the backplane.

According to a second aspect, a manufacturing method for the pixel unit according to the first aspect is provided. The manufacturing method includes:
preparing a backplane; and
manufacturing a display unit, bonding a pre-prepared first target compound semiconductor to the backplane to form a first bonding layer, constructing a first compound light-emitting layer and a second compound light-emitting layer adjacent to each other to form a first device layer, bonding a pre-prepared second target compound semiconductor to a side of the first device layer away from the backplane to form a second bonding layer, and constructing a third compound light-emitting layer and a color conversion layer adjacent to the third compound light-emitting layer to form a second device layer, where the color conversion layer is arranged above the first compound light-emitting layer.

In a preferred implementation, the bonding a pre-prepared first target compound semiconductor to the backplane includes:
plating an entire surface of the backplane on which at least one anode is arranged with an insulating material, and providing at least one through hole corresponding to the at least one anode;
manufacturing a first P-type ohmic contact layer on a surface of the first target compound semiconductor, and plating an entire surface of the first P-type ohmic contact layer with an insulating material;
bonding the backplane to the first target compound semiconductor; and
removing a substrate of the first target compound semiconductor to expose an N-type ohmic contact layer of the first target compound semiconductor.

In a preferred implementation, the constructing a first compound light-emitting layer and a second compound light-emitting layer adjacent to each other to form a first device layer includes:
performing patterned etching on the first target compound semiconductor exposing the N-type ohmic contact layer to form the first compound light-emitting layer and the second compound light-emitting layer adjacent to each other;
wrapping entire surfaces of the first compound light-emitting layer and the second compound light-emitting layer to form a first insulating wrapping layer;
performing patterned etching on the first insulating wrapping layer to respectively form a first anode electrical connection channel, a second anode electrical connection channel, a first cathode electrical connection channel, and a second cathode electrical connection channel; and
performing metal coating on a surface of the first insulating wrapping layer to respectively form a first anode electrical connection structure, a second anode electrical connection structure, a first cathode electrical connection structure, and a second cathode electrical connection structure.

In a preferred implementation, the constructing a third compound light-emitting layer and performing filling to form a color conversion layer adjacent to the third compound light-emitting layer includes:
performing patterned etching on the second target compound semiconductor exposing an N-type ohmic contact layer to form the third compound light-emitting layer;
wrapping an entire surface on which the third compound light-emitting layer is located to form a second insulating wrapping layer;
performing patterned etching on the second insulating wrapping layer, the second bonding layer, the first insulating wrapping layer, and the first bonding layer to respectively form a third anode electrical connection channel, a third cathode electrical connection channel, and a first slot;
filling the first slot with a color conversion material to form the color conversion layer, where the color conversion layer is attached onto the second bonding layer; and
performing metal coating on a surface on which the second insulating wrapping layer is located to respectively form a third anode electrical connection structure connected to a third anode and a third cathode electrical connection structure connected to a cathode, to form the second device layer.

In a preferred implementation, after the second device layer is constructed, the manufacturing method further includes:
performing patterned etching on the second device layer and the first device layer to form an enhanced common cathode channel, part of the enhanced common cathode channel is arranged through and between the third compound light-emitting layer and the color conversion layer, and part of the enhanced common cathode channel is arranged through and between the first compound light-emitting layer and the second compound light-emitting layer; and
performing metal coating on a surface of the second device layer to form an enhanced common cathode, where the enhanced common cathode and a common cathode are connected to enclose a first region and a second region separated from each other.

In a preferred implementation, after the second device layer is constructed, the manufacturing method further includes:
plating a water vapor isolation material on the surface of the second device layer to form a water vapor isolation layer.

According to a third aspect, a manufacturing method for the pixel unit according to the first aspect is provided. The manufacturing method includes:
preparing a backplane; and
bonding a pre-prepared first target compound semiconductor to the backplane, constructing a first compound light-emitting layer and a second compound light-emitting layer adjacent to each other to form a first device layer, bonding a pre-prepared second target compound semiconductor to a side of the first device layer away from the backplane, and constructing a third compound light-emitting layer and a color conversion layer adjacent to the third compound light-emitting layer to form a second device layer, where the color conversion layer is arranged above the first compound light-emitting layer.

In a preferred implementation, the preparing a backplane includes:
etching the pre-prepared backplane to form at least four cavities;
plating a sacrificial layer on a side of the backplane provided with the at least four cavities; and
constructing at least four pads on the side of the backplane plated with the sacrificial layer, where part of each of the pads is embedded in the corresponding cavity, and the at least four pads include one cathode pad and at least three anode pads.

In a preferred implementation, after the second device layer is constructed, the manufacturing method further includes forming an isolation support structure, including:
plating a dielectric material on a surface of a device body and extending the dielectric material to part of a surface of the backplane to form the isolation support structure; and
etching the sacrificial layer on a side surface of the backplane not plated with the dielectric material, to separate the at least four pads from the backplane, where a ratio of an etching rate of the sacrificial layer to an etching rate of the backplane is greater than 10:1, and a ratio of the etching rate of the sacrificial layer to an etching rate of the isolation support structure is greater than 10:1.

According to a fourth aspect, a microdisplay is provided. The microdisplay includes:
a microdisplay backplane, where the microdisplay backplane includes a drive circuit, an input interface, and an output interface;
a display region, where the display region is arranged on the microdisplay backplane, the display region includes at least two display units included in the pixel unit according to the first aspect or at least two display units included in the pixel unit manufactured by using the manufacturing method for a pixel unit according to the second aspect, and the at least two display units are arranged in an array; and
a peripheral common cathode, where the peripheral common cathode is electrically connected to a common cathode of each of the display units respectively.

According to a fifth aspect, a pixel-level discrete device is provided. The pixel-level discrete device includes:
a discrete device backplane, where the discrete device backplane includes at least three anode pads and at least one cathode pad; and
a device body, where the device body is arranged on the discrete device backplane, and the device body includes at least two display units included in the pixel unit according to the first aspect, or at least two display units included in the pixel unit manufactured by using the manufacturing method according to the third aspect.

Compared with the prior art, this application has the following beneficial effects:
This application provides a pixel unit, a manufacturing method therefor, a microdisplay, and a pixel-level discrete device. The pixel unit includes a backplane and a display unit. The display unit is arranged on the backplane, and includes a first device layer and a second device layer vertically stacked sequentially in a direction away from the backplane. The first device layer includes a first compound light-emitting layer and a second compound light-emitting layer adjacent to each other. The second device layer includes a color conversion layer and a third compound light-emitting layer adjacent to each other. The color conversion layer is arranged above the first compound light-emitting layer. According to this application, the color conversion layer is arranged, so that the compound light-emitting layer whose external quantum efficiency is greatly decreased due to the size effect can implement color development through color conversion, to reduce power and improve brightness and other performance. In addition, the pixel unit implements multi-color display by vertically stacking at least two device layers sequentially on the backplane. In this way, the pixel unit occupies less space in the horizontal direction, and the pixel density is less limited. Moreover, the decrease in the external quantum efficiency caused by the size effect is effectively reduced, the power consumption is effectively reduced, and performance such as the brightness is improved, so that the yield can be effectively improved. Most importantly,

In addition, the common cathode in this application is arranged around the periphery of the display unit, to reduce an area proportion of the cathode in the display unit, improve an area proportion of a light-emitting region, and reduce impact of the size effect. In addition, a quantity of stacked device layers in the vertical direction can be increased or redundant circuits can be formed, and optical crosstalk between adjacent pixel units can be effectively prevented and light leakage in the color conversion layer can be avoided.

In addition, the pixel unit in this application further includes an enhanced common cathode. The enhanced common cathode and the common cathode are connected to enclose a first region and a second region separated from each other. The first compound light-emitting layer and the color conversion layer are stacked in the first region. The second compound light-emitting layer and the third compound light-emitting layer are stacked in the second region. The enhanced common cathode is arranged, so that electrical enhancement can be effectively performed and optical crosstalk between adjacent compound light-emitting layers can be effectively prevented. More importantly, light overflow in the first compound light-emitting layer can be effectively prevented.

In addition, the area of the projection of the color conversion layer on the backplane in this application is larger than the area of the projection of the first compound light-emitting layer on the backplane, to avoid light overflow in the first compound light-emitting layer.

In addition, the red light quantum dot material is used in the color conversion layer in this application, and the wavelength of the light source of the first compound semiconductor layer is less than that of red light. In this way, red light is implemented through color conversion, to avoid power consumption and performance defects caused by an external quantum effect due to a size effect in an AlGaInP red light system. Moreover, environmental protection problems caused by the GaAs red light system can be effectively solved, and reliability problems of high activity of green and blue light quantum dots under an ultra-large specific surface area are avoided.

In addition, according to the manufacturing method for a pixel unit in this application, during device preparation, electrical connection of cathodes, and electrical connection of anodes, a damascene-like process is used for passivation and next-step bonding preparation. Compared with an existing solution of etching a metal layer to construct an electrical connection structure, this solution reduces the process difficulty in constructing an electrical connection in a stacking solution, and in particular, improves feasibility of using a metal (for example, copper) having difficulty of being dry-etched as an electrical connection structure.

It should be noted that, this application only needs to achieve at least one of the foregoing technical effects.

### BRIEF DESCRIPTION OF THE DRAWINGS

FIG. 1 is a schematic structural diagram of a pixel unit in Embodiment 1 from a top view;
FIG. 2 is a cross-sectional view of a cross section x-x in FIG. 1;
FIG. 3 is a cross-sectional view of a cross section y₁-y₁ in FIG. 1;
FIG. 4 is a cross-sectional view of a cross section y₂-y₂ in FIG. 1;
FIG. 5 is a cross-sectional view of a cross section y₃-y₃ in FIG. 1;
FIG. 6 is a schematic diagram of an exemplary circuit structure of a backplane in Embodiment 1;
FIG. 7 is a schematic diagram of a circuit structure of any device layer in Embodiment 1;
FIG. 8 is a schematic diagram of an exemplary circuit structure of another backplane in Embodiment 1;
FIG. 9 is a structural diagram in which a top metal is arranged on a surface of the backplane in Embodiment 1;
FIG. 10 is a structural diagram in which an in-situ mirror is arranged on the surface of the backplane in Embodiment 1;
FIG. 11 shows reflectance data in a visible light wavelength range of an exemplary in-situ mirror in Embodiment 1;
FIG. 12 is a schematic structural diagram of the pixel unit in Embodiment 1 from a top view, where the pixel unit includes an enhanced common cathode;
FIG. 13 is a cross-sectional view of a cross section x-x in FIG. 12;
FIG. 14 is a cross-sectional diagram of a cross section x-x of another pixel unit in Embodiment 1, where the pixel unit includes an enhanced common cathode;
FIG. 15 is a cross-sectional view of a cross section x-x of another pixel unit in Embodiment 1;
FIG. 16 is an x-x cross-sectional view of a pixel unit having an optical enhancement structure and an enhanced common cathode in Embodiment 1;
FIG. 17 is a schematic diagram of an exemplary actual CSP packaging arrangement in Embodiment 1;
FIG. 18 is a schematic structural diagram of a microdisplay in Embodiment 2;
FIG. 19 is a schematic diagram of an arrangement of adjacent pixel units in the microdisplay in Embodiment 2;
FIG. 20 is a cross-sectional view of a cross section A-B in FIG. 19;
FIG. 21 is a schematic diagram of another arrangement of adjacent pixel units in the microdisplay in Embodiment 2;
FIG. 22 is a cross-sectional view of a cross section C-D in FIG. 21;
FIG. 23 is a cross-sectional view of sharing a common cathode between adjacent pixel units in Embodiment 2;
FIG. 24 is a top view of a pixel-level discrete device in Embodiment 3;
FIG. 25 is a cross-sectional view in an X-X direction in FIG. 24;
FIG. 26 is an expanded view of a section A-B in FIG. 24;
FIG. 27 is a cross-sectional view in another X-X direction in Embodiment 3 (where a sacrificial layer is not removed and there is no isolation support structure);
FIG. 28 is a top view of a backplane provided with pads in Embodiment 3;
FIG. 29 is a cross-sectional view in a C-D direction in FIG. 28 (where a sacrificial layer and solid pads are included); and
FIG. 30 is another cross-sectional view in the direction C-D in FIG. 28 (where a sacrificial layer and hollow pads are included).

### Reference numerals:

100, 100': pixel unit; 10, 10': backplane; 11: top metal; 12: in-situ mirror; 13: first anode; 14: second anode; 15: third anode; 20: display unit; 30, 30': common cathode; 31, 31': first cathode electrical connection structure; 32, 32': second cathode electrical connection structure; 33, 33': third cathode electrical connection structure; 40, 40': first device layer; 41, 41': first compound light-emitting layer; 411, 411': first P-type ohmic contact layer; 412, 412': first compound semiconductor layer; 42, 42': second compound light-emitting layer; 421, 421': second P-type ohmic contact layer; 422, 422': second compound semiconductor layer; 43, 43': first bonding layer; 44, 44': first anode electrical connection structure; 45, 45': second anode electrical connection structure; 46, 46': first insulating wrapping layer; 50, 50': second device layer; 51, 51': color conversion layer; 52, 52': third compound light-emitting layer; 521, 521': third P-type ohmic contact layer; 522, 522': third compound semiconductor layer; 53, 53': second bonding layer; 54, 54': third anode electrical connection structure; 55, 55': second insulating wrapping layer; 60, 60': enhanced common cathode; 61, 61': first region; 62, 62': second region; 70: water vapor isolation layer; 70': isolation support structure; 71': covering portion; 72': fixing portion; 80: optical enhancement structure; 80': sacrificial layer; 200: microdisplay; 300: drive backplane; 400: display region; 500: peripheral common cathode; and 600: external IO interface.

### DETAILED DESCRIPTION

To make objectives, technical solutions, and advantages of this application clearer, the technical solutions in the embodiments of this application will be clearly and completely described below with reference to the accompanying drawings in the embodiments of this application. It is obvious that the embodiments to be described are only a part rather than all of the embodiments of this application. All other embodiments obtained by a person of ordinary skill in the art based on the embodiments of this application without creative efforts shall fall within the protection scope of this application.

In the description of this application, it should be understood that orientation or position relationships indicated by the terms such as "upper", "lower", "inner", and "outer" are based on orientation or position relationships shown in the accompanying drawings, and are used only for ease and brevity of illustration and description, rather than indicating or implying that the mentioned apparatus or component needs to have a particular orientation or needs to be constructed and operated in a particular orientation. Therefore, such terms should not be construed as limiting of this application. In addition, terms "first" and "second" are used merely for the purpose of description, and shall not be construed as indicating or implying relative importance or implying a quantity of indicated technical features. Therefore, features defining "first" and "second" may explicitly or implicitly include one or more such features. In the description of this application, unless otherwise stated, "a plurality of" means two or more than two.

In the description of this application, it should be noted that unless otherwise explicitly specified or defined, the terms such as "mount", "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two components. A person of ordinary skill in the art may understand the specific meanings of the foregoing terms in this application according to specific situations.

### Embodiment 1

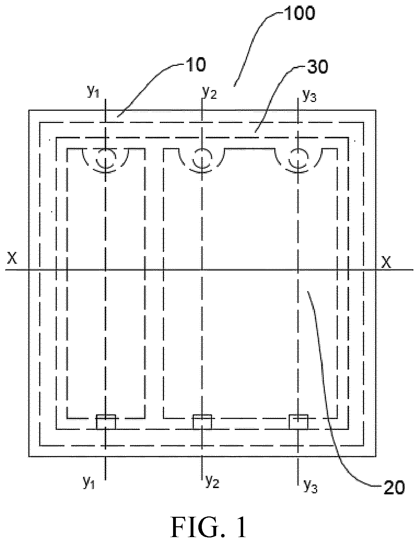

As shown in FIG. 1 to FIG. 5, an embodiment provides a pixel unit 100. The pixel unit 100 is used in a semiconductor device. The pixel unit 100 includes a backplane 10, a display unit 20, and a common cathode 30. The pixel unit 100 provided in this embodiment is a vertical stack pixel (VSP for short). The pixel unit 100 is used in semiconductor devices such as a microdisplay and an invisible light detector.

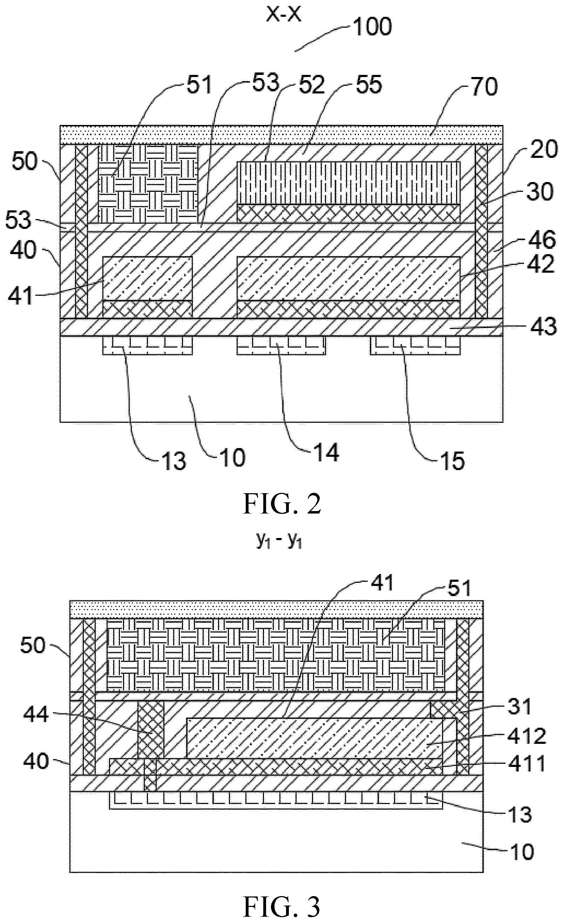

FIG. 1 is a top view of the pixel unit 100, where a dotted-line part indicates a main internal structure of the pixel unit, which is the same below. FIG. 2 to FIG. 5 are respectively two cross-sectional views in FIG. 1 (the top view). Subsequent structural diagrams are all top views or corresponding cross-sectional views under the current structure. An involved x-x cross-sectional view is a horizontal cross-sectional view in a top view, and a y-y cross-sectional view is a vertical cross-sectional view in a top view.

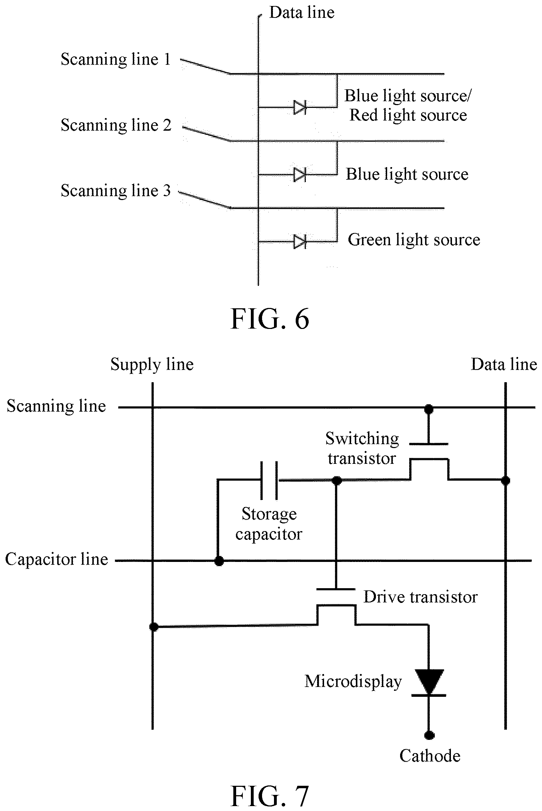

Specifically, the backplane 10 is provided with a drive circuit. The drive circuit 10 is provided with at least one anode. For example, a circuit diagram of the drive circuit is shown in FIG. 6. It should be noted that the circuit diagram in this embodiment is a simple schematic diagram, and circuits are all actively driven. An internal circuit of the pixel unit 100 may include an active, passive, or semi-passive control circuit. For example, FIG. 7 is a circuit diagram of any device layer. Anodes in this embodiment may be arranged on a same straight line, arranged in a triangularly stacked manner, or arranged in an array. Any anode is located in the middle or at an edge of the backplane 10. This is not limited in this embodiment.

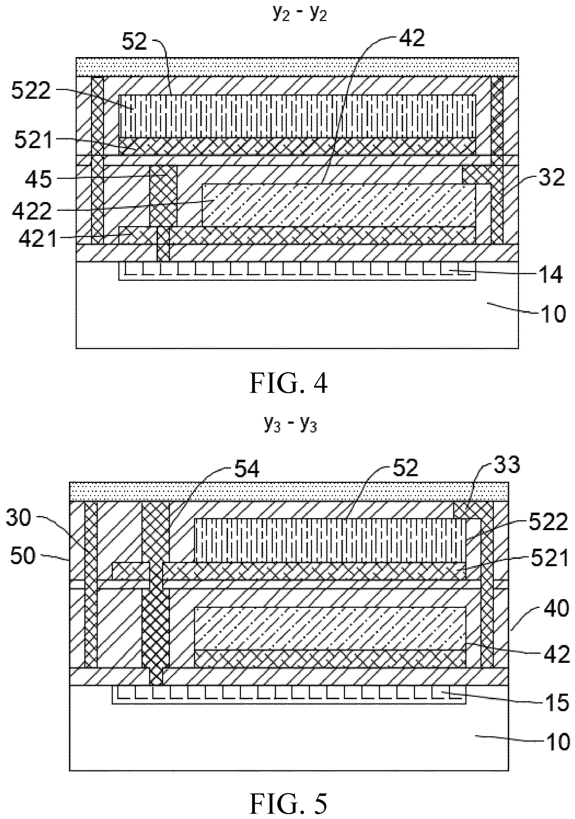

Still refer to FIG. 1 and FIG. 5. A display unit 20 is arranged on a side surface of the backplane 10 on which at least one anode is arranged. The display unit 20 includes a first device layer 40 and a second device layer 50 vertically stacked sequentially in a direction away from the backplane 10. The first device layer 40 includes a first compound light-emitting layer 41 and a second compound light-emitting layer 42 adjacent to each other. The second device layer 50 includes a color conversion layer 51 and a third compound light-emitting layer 52 adjacent to each other. The color conversion layer 51 is arranged above the first compound light-emitting layer 41.

It should be noted that any device layer in this embodiment may be a common graphic or a combination of graphics such as a quadrilateral, a hexagon, an octagon, and a circle. This is not further limited in this embodiment.

Certainly, in this embodiment, materials of the compound light-emitting layers used in the display unit 20 may be the same or different. An exemplary combination may be as follows: A red light quantum dot material is used in the color conversion layer 51, and any same or different light sources other than red light are used in the first compound light-emitting layer 41, the second compound light-emitting layer 42, and the third compound light-emitting layer 52, which are preferably one of ultraviolet, blue light, and green light. A wavelength of a light source of the first compound semiconductor layer 412 is less than that of red light. It should be noted that the compound semiconductor layers in this embodiment are all quantum well compound semiconductor layers.

In addition, a quantity of device layers stacked in the vertical direction of the display unit 20 includes but is not limited to two layers, and may be three layers, four layers, or even more. It is only necessary to determine that all layers in the vertical direction of the color conversion layer 51 are transparent layers, so that no light is blocked or no large light loss is caused to the color conversion layer 51.

For example, when compounds of the compound light-emitting layers are different, multi-color display such as full-color display can be implemented. When a same compound is used in two or more compound light-emitting layers in the vertical direction, light intensity can be enhanced or a redundant structure can be formed. Certainly, the two solutions may exist in the same display unit 20. This is not limited in this embodiment.

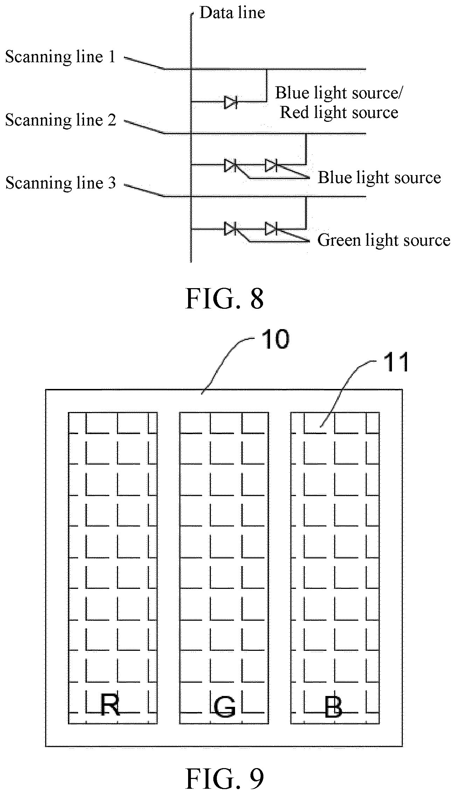

Further, when multi-color display is implemented, the first compound light-emitting layer 41, the second compound light-emitting layer 42, and the third compound light-emitting layer 52 are respectively connected to different anodes to implement separate control of light sources of different colors. A circuit structure is shown in FIG. 6. When light intensity is enhanced, for example, same compound light-emitting layers are connected to a same anode in series or in parallel, and a circuit structure is shown in FIG. 8.

For ease of description, in this embodiment, two device layers are as an example for further detailed description. In addition, a blue light InGaN compound epitaxial material is used in the first compound light-emitting layer 41 and the second compound light-emitting layer 42, a green light InGaN compound epitaxial material is used in the third compound light-emitting layer 52, and a red light quantum dot material is used in the color conversion layer 51, to implement RGB full-color display.

The backplane 10 in this embodiment may be an active backplane in which one or more of a thin film transistor (TFT), an LTPS low-temperature polysilicon, a CMOS integrated circuit, a high electron mobility transistor (HEMT), and the like are combined.

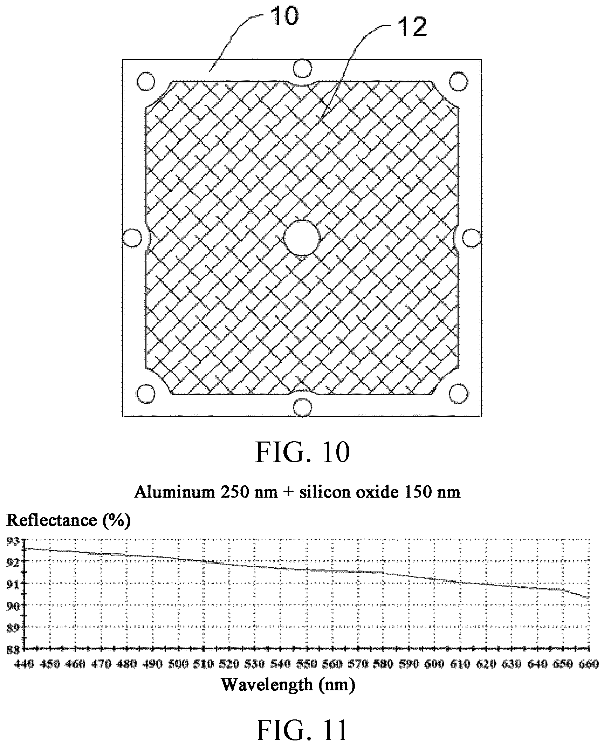

In this embodiment, a CMOS integrated circuit backplane is selected. The backplane 10 includes at least one top metal 11. The top metal 11 covers at least one anode (FIG. 9). Alternatively, the backplane 10 includes an in-situ mirror 12 arranged on an upper surface of the backplane, and the in-situ mirror 12 covers or exposes at least one anode (FIG. 10). The in-situ mirror 12 may be a metal, for example, aluminum, gold, or silver, or may be a Bragg reflection layer. The Bragg reflection layer is formed by stacking two or more thin films with different refractive indexes, for example, a stack of silicon oxide and titanium oxide, a stack of silicon oxide and aluminum oxide, or a stack of silicon oxide and silicon nitride, or may be an ODR total reflection mirror formed by stacking a metal and a dielectric, for example, at least one combination of silver and silicon oxide, aluminum and aluminum oxide, or gold and silicon oxide. For example, reflectance data of a stack of 250 nm metallic aluminum and 150 nm silicon oxide (where a target wavelength is 620 nm with 1/4 being 150 nm) in some visible light wavelength ranges is shown in FIG. 11.

The in-situ mirror 12 may be a polygonal structure such as a circle, a triangle, a quadrilateral, a pentagon, a hexagon, or an octagon, or may be a combined polygon that avoids an anode contact. The polygon may be inscribed to a pixel boundary, or may be inscribed by a length relative to the boundary.

The common cathode 30 in this embodiment is arranged around a periphery of the display unit 20. The common cathode 30 is respectively connected to the first compound light-emitting layer 41, the second compound light-emitting layer 42, and the third compound light-emitting layer 52. The common cathode 30 is connected to an external cathode (not shown in the figure). A material of the common cathode 30 is a metal such as Cu or Al.

Specifically, the common cathode 30 is a metal surrounding frame around the periphery of the display unit 20, and includes a first cathode electrical connection structure 31 connected to the first compound light-emitting layer 41, a second cathode electrical connection structure 32 connected to the second compound light-emitting layer 42, and a third cathode electrical connection structure 33 connected to the third compound light-emitting layer 52.

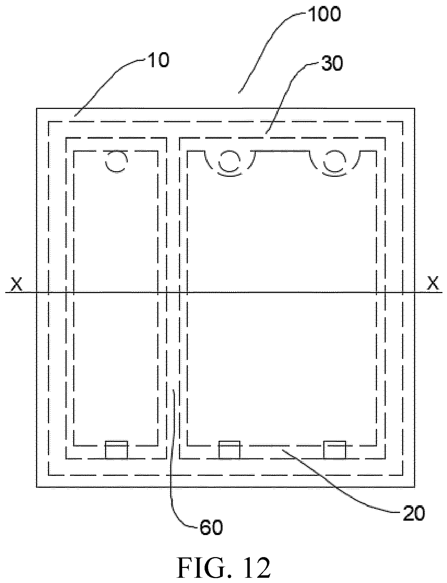

Further preferably, as shown in FIG. 12 to FIG. 14, the pixel unit 100 further includes an enhanced common cathode 60. The enhanced common cathode 60 and the common cathode 30 are connected to enclose a first region 61 and a second region 62 separated from each other. Part of the enhanced common cathode 60 is arranged through and between the third compound light-emitting layer 52 and the color conversion layer 51, and part of the enhanced common cathode 60 is arranged through and between the first compound light-emitting layer 41 and the second compound light-emitting layer 42.

The first compound light-emitting layer 41 and the color conversion layer 51 are stacked in the first region 61, and the second compound light-emitting layer 42 and the third compound light-emitting layer 52 are stacked in the second region 62. A material of the enhanced common cathode 60 is a metal such as Cu or Al.

The first device layer 40 further includes a first bonding layer 43, a first anode electrical connection structure 44, a second anode electrical connection structure 45, and a first insulating wrapping layer 46. The first bonding layer 43 is attached onto the backplane 10, and the first compound light-emitting layer 41 and the second compound light-emitting layer 42 are respectively attached onto a side of the first bonding layer 43 away from the backplane 10. In addition, an end of the first anode electrical connection structure 44 is connected to a corresponding first anode 13, and an other end of the first anode electrical connection structure is connected to the first compound light-emitting layer 41. An end of the second anode electrical connection structure 45 is connected to a corresponding second anode 14, and an other end of the second anode electrical connection structure is connected to the second compound light-emitting layer 42.

The first insulating wrapping layer 46 wraps the first compound light-emitting layer 41, the second compound light-emitting layer 42, the first anode electrical connection structure 44, the second anode electrical connection structure 45, and part of the common cathode 30. The part of the common cathode 30 includes but is not limited to the first cathode electrical connection structure 31 and the second cathode electrical connection structure 32.

The first bonding layer 43 is made of an insulating material including a dielectric material such as SiO₂, Si₃N₄, Al₂O₃, or AlN, or a semiconductor material such as Si, or an organic material such as SU₈ or BCB. The first insulating wrapping layer 46 is made of a transparent insulating material, for example, SiO₂. The anode electrical connection structures and the cathode electrical connection structures are all made of corresponding metals, such as Cu and Al.

Further, the first compound light-emitting layer 41 includes a first P-type ohmic contact layer 411, a first compound semiconductor layer 412, and a first N-type ohmic contact layer (not shown in the figure) sequentially attached. The first P-type ohmic contact layer 411 is fittedly attached to the first bonding layer 43, and an area of the first P-type ohmic contact layer 411 is larger than an area of the first compound semiconductor layer 412. The first anode electrical connection structure 44 is arranged opposite to a side of the first compound semiconductor layer 412. Part of the first anode electrical connection structure 44 passes through the first P-type ohmic contact layer 411 and the first bonding layer 43 sequentially and is connected to the corresponding first anode 13. Therefore, the first compound light-emitting layer 41 is connected to the first anode 13 through the first anode electrical connection structure 44. Specifically, an end of the first anode electrical connection structure 44 is connected to the first P-type ohmic contact layer 411, and an other end of the first anode electrical connection structure is connected to the first anode 13. In addition, the first compound light-emitting layer 41 is connected to the common cathode 30 through connection between the first N-type ohmic contact layer and the first cathode electrical connection structure 31.

A material of the first P-type ohmic contact layer 411 may be a transparent conductive material such as ITO, or may be a stack or an alloy of metal materials such as Au, Ni, Ag, and Mg. The first P-type ohmic contact layer 411 is formed by performing ITO coating on the first compound semiconductor layer 412 through evaporation, sputtering, or other methods. Preferably, a thickness of the ITO film is 500 nm, and ohmic contact is formed through high-temperature annealing at 500°C in an N₂ environment.

Further, the second compound light-emitting layer 42 includes a second P-type ohmic contact layer 421, a second compound semiconductor layer 422, and a second N-type ohmic contact layer (not shown in the figure) sequentially attached. The second P-type ohmic contact layer 421 is fittedly attached to the first bonding layer 43, and an area of the second P-type ohmic contact layer 421 is larger than an area of the second compound semiconductor layer 422. The second anode electrical connection structure 45 is arranged opposite to a side of the second compound semiconductor layer 422. Part of the second anode electrical connection structure 45 passes through the second P-type ohmic contact layer 421 and the first bonding layer 43 sequentially and is connected to the corresponding second anode. Therefore, similarly, the second compound light-emitting layer 42 is connected to the second anode 14 through the second anode electrical connection structure 45. Specifically, an end of the second anode electrical connection structure 45 is connected to the second P-type ohmic contact layer 421 and an other end of the second anode electrical connection structure is connected to the second anode 14. In addition, the second compound light-emitting layer 42 is connected to the common cathode 30 through connection between the second N-type ohmic contact layer and the second cathode electrical connection structure 32.

The second device layer 50 further includes a second bonding layer 53, a third anode electrical connection structure 54, and a second insulating wrapping layer 55. The second bonding layer 53 is attached onto the first device layer 40, and the color conversion layer 51 and the third compound light-emitting layer 52 are respectively attached onto a side of the second bonding layer 53 away from the first device layer 40. Preferably, an area of a projection of the color conversion layer 51 on the backplane 10 is larger than an area of a projection of the first compound light-emitting layer 41 on the backplane 10.

It should be noted that a target color light source is obtained by using the color conversion layer 51 in this embodiment. Specifically, when light emitted by the first compound light-emitting layer 41 passes through the color conversion layer 51, light color conversion is performed to form the target color light source. A photochromic material is used in the color conversion layer 51, and is preferably at least one of a quantum dot material or a phosphor material. The color conversion layer 51 in this embodiment is configured for forming a red light source. Therefore, preferably, a red light quantum dot material or a red phosphor material is used in the color conversion layer 51. The red light quantum dot material may be a perovskite red light quantum dot (where the quantum dot material may be at least one of a CsPdI₃ material, an InP material, a CdSe material, or a CdS material). Based on this, the wavelength of the light source of the first compound semiconductor layer 412 is less than that of the red light, so that light is transmitted through the first compound semiconductor layer 412.

The second bonding layer 53 is made of a transparent insulating material including SiO₂ or the like. The second insulating wrapping layer 55 is made of a transparent insulating material, for example, SiO₂. The anode electrical connection structures and the cathode electrical connection structures are all made of corresponding metals, such as Cu and Al.

The third compound light-emitting layer 52 includes a third P-type ohmic contact layer 521, a third compound semiconductor layer 522, and a third N-type ohmic contact layer (not shown in the figure) sequentially attached. The third P-type ohmic contact layer 521 is fittedly attached to the second bonding layer 53, and an area of the third P-type ohmic contact layer 521 is larger than an area of the third compound semiconductor layer 522. The third anode electrical connection structure 54 is arranged opposite to a side of the third compound semiconductor layer 522. Part of the third anode electrical connection structure 54 passes through the third P-type ohmic contact layer 521, the second bonding layer 53, and the first bonding layer 43 sequentially and is connected to a corresponding third anode 15. Therefore, an end of the third anode electrical connection structure 54 is connected to the third P-type ohmic contact layer 521, and an other end of the third anode electrical connection structure is connected to the third anode 15, to implement connection between the third compound light-emitting layer 52 and the third anode 15. In addition, the third cathode electrical connection structure 33 is connected to the third N-type ohmic contact layer, to implement connection between the third compound light-emitting layer 52 and the common cathode 30.

The second insulating wrapping layer 55 wraps the color conversion layer 51, the third compound light-emitting layer 52, the third anode electrical connection structure 54, and part of the common cathode 30. The part of the common cathode 30 includes but is not limited to, the third cathode electrical connection structure 33.

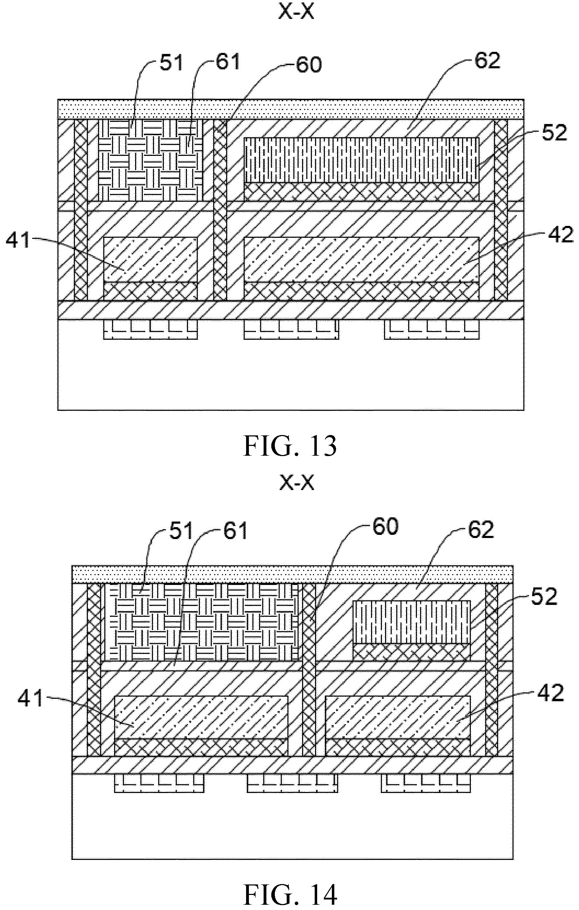

Preferably, as shown in FIG. 14, to reduce absorption and loss of light emitted by the second compound light-emitting layer 42 by the third compound light-emitting layer 52, an area of a projection of the third compound light-emitting layer 52 on the backplane 10 is smaller than that of the second compound light-emitting layer 42, and a size of each light-emitting layer may be adjusted based on different color ratios.

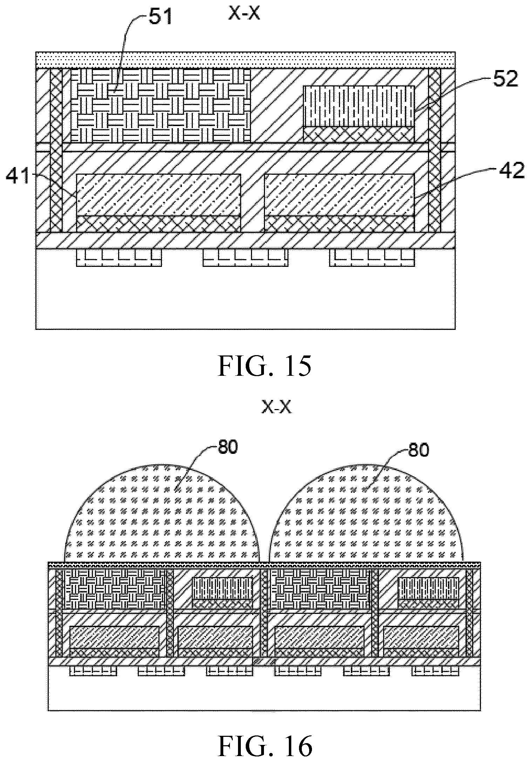

For example, as shown in FIG. 15, a common microdisplay device uses a monochrome 4 µm pixel size as an example, and a device size is 2 µm. If RGBs are stacked horizontally, a pixel size is 4*12 µm; and if the RGBs are stacked in a triangularly stacked manner, the pixel size is 8*8 µm. A brightness of a red-emitting AlGaInP device is 0.2 million nits (about 20 mw), a brightness of a green-emitting InGaN device is 3 million nits (about 120 mw), and a brightness of a blue-emitting InGaN device is 0.5 million nits (about 120 mw). Required white light is composed of three colors of red, green, and blue, with a ratio of 35% red light, 50% green light, and 15% blue light. A brightness of the composed white light is greatly affected by red- and blue-emitting devices. In particular, red light brightness is severely insufficient. In an implementation, the first compound light-emitting layer 41 (a backlight source) and the second compound light-emitting layer 42 emit blue light, and the third compound light-emitting layer 52 emit green light. The pixel size (area) is adjusted for collocation, sizes of the first compound light-emitting layer 41 and the second compound light-emitting layer 42 are increased, and a sub-pixel device size of the third compound light-emitting layer 52 is reduced to achieve a better ratio. Perovskite red light quantum dots are used in the quantum dot material (where the quantum dot material may be a CsPdI3 material, an InP material, a CdSe material, or a CdS material), where conversion efficiency of the CsPdI3 material exceeds 80%. The pixel size is 5*5 µm, a pixel size of blue light as the backlight source is 2.5*4 µm, a size of a blue primary sub-pixel is 1.5*4 µm, and a size of a green primary sub-pixel is 1*4 µm. A brightness after color conversion is 1.2 million nits (about 240 mw) for red light, 3 million nits (about 120 mw) for green light, and 75 million nits (about 180 mw) for blue light, to greatly increase the brightness while reducing the pixel size.

It should be noted that the first compound light-emitting layer 41 and the color conversion layer 51 are spaced by a distance to implement thermal isolation and avoid a decrease in thermal stability caused by direct contact between the photochromic material in the color conversion layer 51 and the backlight source. The distance may be determined based on a thickness of the second bonding layer 53 and a thickness of the color conversion layer 51. This is not specifically limited in this embodiment. Preferably, the distance is 0.1 to 5 µmm. Certainly, layers implementing thermal isolation include but are not limited to the first insulating wrapping layer 46 and the second bonding layer 53.

In addition, the display unit 20 further includes a water vapor isolation layer 70 arranged on a surface of the second device layer 50. Specifically, the water vapor isolation layer 70 is made of a transparent dielectric material. The transparent dielectric material includes a single layer or a plurality of layers of an inorganic dielectric material such as silicon oxide, silicon nitride, aluminum oxide, titanium oxide, or diamond, or may be an organic dielectric material such as SU8 or polyimide, or may be a polycrystalline material such as glass or soda. Preferably, the water vapor isolation layer 70 is a Bragg reflection layer formed by a stack of silicon oxide and titanium oxide. The water vapor isolation layer 70 on the surface of the third compound light-emitting layer 52 is removed by etching. The water vapor isolation layer 70 can function as a light filter, allowing only a red light band to be transmitted.

In addition, the pixel unit 100 further includes an optical enhancement structure 80. The optical enhancement structure 80 is stacked on a surface of the water vapor isolation layer 70. Details are shown in FIG. 16. The optical enhancement structure 80 may be a polarizer, a lens, or the like. The lens may be an organic material, such as SU8 or polyimide, or may be an inorganic material, such as silicon oxide or aluminum oxide.

Corresponding to the foregoing pixel unit 100, an embodiment further provides a manufacturing method for a pixel unit for a semiconductor device. The manufacturing method includes:

### S1: Prepare a backplane.

Specifically, the backplane may be one or more active backplanes such as a thin film transistor (TFT), a LTPS low-temperature polysilicon, a CMOS integrated circuit, and a high electron mobility transistor (HEMT). A CMOS integrated circuit backplane is selected, including at least one anode. Certainly, a surface of the backplane is provided with at least one top metal covering the anode, or an in-situ mirror is arranged on the surface of the backplane. In this embodiment, the top metal is preferably arranged.

S2: Manufacture a display unit, bond a pre-prepared first target compound semiconductor to the backplane to form a first bonding layer, construct a first compound light-emitting layer and a second compound light-emitting layer adjacent to each other to form a first device layer, bond a pre-prepared second target compound semiconductor to a side of the first device layer away from the backplane to form a second bonding layer, and construct a third compound light-emitting layer and a color conversion layer adjacent to the third compound light-emitting layer to form a second device layer, where the color conversion layer is arranged above the first compound light-emitting layer.

Specifically, step S2 includes:
S21: Bond a pre-prepared first target compound semiconductor to the backplane, including:
S211: Plate an entire surface of the backplane on which at least one anode is arranged with an insulating material (a bonding material), and provide at least one through hole corresponding to the at least one anode.
S212: Manufacture a first P-type ohmic contact layer on a surface of the first target compound semiconductor, and plating an entire surface of the first P-type ohmic contact layer with an insulating material (a bonding material).

Preferably, an InGaN ternary compound is used in the first target compound semiconductor. A structural diagram of the first target compound semiconductor may be any compound structure of a wavelength such as blue light or green light as shown in Table 1 or Table 2 below. The blue light compound is preferably used in the first target compound semiconductor in this embodiment.

**Table 1**

| Layer name | Material |
|---|---|
| P-type ohmic contact layer | P-GaAs |
| Quantum well compound semiconductor layer | InGaN & GaN |
| N-type ohmic contact layer | GaN |
| Etching cut-off layer | AlN & GaN |
| Substrate | Si |

**Table 2**

| Layer name | Material |
|---|---|
| P-type ohmic contact layer | P-GaN |
| Quantum well compound semiconductor layer | InGaN & GaN |
| N-type ohmic contact layer | GaN |
| Etching cut-off layer | InGaN |
| Substrate | GaN |

The quantum well compound semiconductor layer is the compound semiconductor layer in this embodiment. The etching cut-off layer has a height ratio to the substrate. The etching cut-off layer is configured for protection of remaining compounds during substrate removal.

Therefore, before step S212, the manufacturing method further requires pre-preparation of the first target compound semiconductor, specifically including:
selecting a blue light InGaN ternary compound whose substrate includes materials such as Si, sapphire, and Ga₂O₃;
forming a P-type ohmic contact film on a P contact surface, where a P-type contact material may be a transparent conductive material such as ITO or ZnO, or may be a stack or an alloy of metal materials such as Ni, Au, and Ag; for example, ITO coating is performed through evaporation, sputtering, or other methods, a thickness of the ITO film is 500 nm, and the first P-type ohmic contact layer is formed through high-temperature annealing at 500°C in an N₂ environment; and certainly, the thickness of the first P-type ohmic contact layer and the condition for forming the contact layer may be adjusted and changed according to requirements; and
plating an entire surface of a side of the first P-type ohmic contact layer of the first target compound semiconductor with an insulating material.

S213: Bond the backplane to the first target compound semiconductor. Specifically, the side of the backplane provided with the insulating material is bonded to the side of the first target compound semiconductor provided with the insulating material to form the first bonding layer.

Preferably, a surface of the insulating material is planarized through chemical mechanical planarization (CMP) (where surface roughness after the CMP planarization ≤ 10 nm), and the surface of the insulating material is activated by using a plasma surface (where the plasma activation solution is processing in an Ar plasma atmosphere with a power of 200 W for three minutes), to render the surface of the insulating material hydrophilic. A first layer of compounds is then vertically stacked at a low temperature, and the first target compound semiconductor is bonded and integrated onto the backplane.

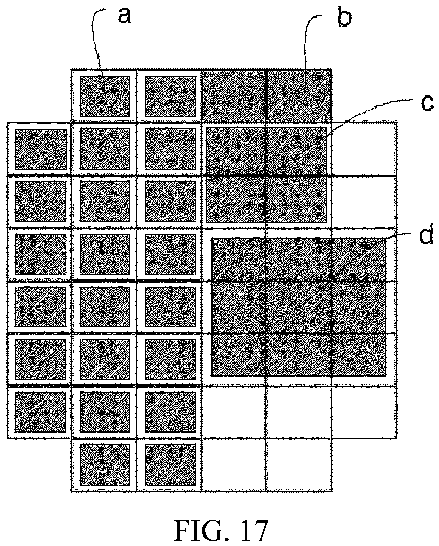

For example, in an actual manufacturing process, as shown in FIG. 17, a cut compound is used. A semi-manufactured compound that is slightly larger (≥ 10 µm) than a display pixel region (display unit) of the backplane is bonded and integrated through chip-scale packaging. chip-scale packaging may be packaging of a single chip as shown in a, packaging of two chips as shown in b, packaging of four chips as shown in c, packaging of nine chips as shown in d, or the like. In a specific implementation, after the P-type ohmic contact and the bonding layer are completed by using a compound wafer, region screening is performed by using a test method. A good product region is selected and cut to obtain a semi-manufactured compound through chip-scale packaging, and bonding and integration are performed through coarse alignment bonding.

S214: Remove a substrate of the first target compound semiconductor to expose an N-type ohmic contact layer of the first target compound semiconductor.

Specifically, after bonding is completed, a blue light compound substrate (Si substrate) is thinned by grinding, and then polished or etched (dry etching or wet etching) through SF₆ to completely remove the compound Si substrate, to expose the N-type ohmic contact layer (a GaN compound).

S22: Construct a first compound light-emitting layer and a second compound light-emitting layer adjacent to each other to form a first device layer, including:
S221: Perform patterned etching on the first target compound semiconductor exposing the N-type ohmic contact layer to form the first compound light-emitting layer and the second compound light-emitting layer adjacent to each other, etch part of the first compound light-emitting layer to the first P-type ohmic contact layer, and etch part of the second compound light-emitting layer to the second P-type ohmic contact layer.
S222: Wrap entire surfaces of the first compound light-emitting layer and the second compound light-emitting layer to form a first insulating wrapping layer. For example, the surfaces of the first compound light-emitting layer and the second compound light-emitting layer are plated with SiO₂ through atomic layer deposition (ALD) to form the first insulating wrapping layer.
S223: Perform patterned exposure and etching on the first insulating wrapping layer to respectively form a first anode electrical connection channel, a second anode electrical connection channel, a first cathode electrical connection channel, and a second cathode electrical connection channel.
S224: Perform metal coating on a surface on which the first insulating wrapping layer is located to respectively form a first anode electrical connection structure, a second anode electrical connection structure, a first cathode electrical connection structure, and a second cathode electrical connection structure. The first anode electrical connection structure is connected to the first anode, the second anode electrical connection structure is connected to the second anode, and the first cathode electrical connection structure and the second cathode electrical connection structure are respectively connected to the cathode.

It should be noted that in this embodiment, during device preparation and construction of the cathode electrical connection structure and the anode electrical connection structure, a damascene-like process is used for passivation and next-step bonding preparation. In a specific implementation, device layer preparation is implemented through patterned etching, the insulating wrapping layer is then introduced, and finally the first anode electrical connection structure, the second anode electrical connection structure, the first cathode electrical connection structure, and the second cathode electrical connection structure are prepared through patterned evaporation or patterned etching. This is the damascene-like process.

S23: Bond a pre-prepared second target compound semiconductor to a side of the first device layer away from the backplane to form a second bonding layer, including:
After the first device layer is constructed in step S23, the second device layer is then constructed. Similar to the description in step S21, the second target compound semiconductor needs to be prepared first. The second target compound semiconductor is configured for forming a third target compound layer. In addition, in this embodiment, the second target compound semiconductor is based on a green light system, and a structure thereof is as described above. Moreover, a bonding process in this step is similar to that in step S21 and details are not described herein again. It should be noted that the second bonding layer is made of a transparent insulating material, for example, a transparent dielectric material such as SiO₂, Si₃N₄, Al₂O₃, or AlN, a light-transparent semiconductor material such as ultra-thin Si, or a transparent organic material such as SU8 or BCB. For example, the second target compound semiconductor is a Si-based green light compound epitaxial layer.

S24: Construct a third compound light-emitting layer and perform filling to form a color conversion layer adjacent to the third compound light-emitting layer, including:
S241: Perform patterned exposure and etching on the second target compound semiconductor exposing an N-type ohmic contact layer to form the third compound light-emitting layer, and etch part of the third compound light-emitting layer to the third P-type ohmic contact layer.
S242: Wrap an entire surface on which the third compound light-emitting layer is located to form a second insulating wrapping layer.
S243: Perform patterned etching on the second insulating wrapping layer, the second bonding layer, the first insulating wrapping layer, and the first bonding layer to respectively form a third anode electrical connection channel, a third cathode electrical connection channel, and a first slot.
S244: Fill the first slot with a color conversion material to form the color conversion layer, where the color conversion layer is attached onto the second bonding layer.

Specifically, the first slot is filled with the color conversion material through spray printing, spin coating, patterning, or imprinting, and then the color conversion material is planarized through CMP planarization or scraper blading.

S245: Perform metal coating on a surface on which the second insulating wrapping layer is located to respectively form a third anode electrical connection structure and a third cathode electrical connection structure, to form the second device layer.

Similarly, in step 24, the cathode electrical connection structure and the anode electrical connection structure are constructed by using the damascene-like process.

S3: Construct an enhanced common cathode, including:
S31: Perform patterned etching on the second device layer and the first device layer to form an enhanced common cathode channel, part of the enhanced common cathode channel is arranged through and between the third compound light-emitting layer and the color conversion layer, and part of the enhanced common cathode channel is arranged through and between the first compound light-emitting layer and the second compound light-emitting layer.
S32: Perform metal coating on a surface of the second device layer to form an enhanced common cathode, where the enhanced common cathode and a common cathode are connected to enclose a first region and a second region separated from each other.
S4: Plate a water vapor isolation material on the surface of the second device layer to form a water vapor isolation layer. Specifically, Al₂O₃ coating is performed on the surface of the second device layer by using an ALD process, to form the water vapor isolation layer for water vapor isolation, thereby enhancing stability of the color conversion material.

Certainly, after step S4, structures such as a black matrix (BM), a polarization, and a Lens may be further added to the surface of the water vapor isolation layer to further adjust light emission. The BM may be metal or a dedicated black colloid. The polarization may be implemented through a Bragg reflection layer. The lens may be an inorganic dielectric layer or an organic colloid. In an embodiment, a semi-spherical lens structure for light extraction is added. The lens structure is made by using SU8.

In conclusion, according to the pixel unit for a semiconductor device provided in this embodiment, multi-color display is implemented by vertically stacking at least two device layers sequentially on the backplane. Compared with a horizontally stacked pixel structure that implements full color, the pixel unit in this application occupies less space in the horizontal direction. Compared with a pixel unit horizontally arranged, the pixel density is less limited. Moreover, the decrease in the external quantum efficiency caused by the size effect is effectively reduced, the power consumption is effectively reduced, and performance such as the brightness is improved. In addition, through multilayer stacking in the vertical direction, the yield can be effectively improved. The color conversion layer is arranged, so that the compound light-emitting layer whose external quantum efficiency is greatly decreased due to the size effect can implement color development through color conversion, to further reduce power and improve performance such as the brightness.

In addition, the common cathode in this embodiment is arranged around the periphery of the display unit, to reduce an area proportion of the cathode in the display unit, improve an area proportion of a light-emitting region, and reduce impact of the size effect. In addition, a quantity of stacked device layers in the vertical direction can be increased or redundant circuits can be formed, and optical crosstalk between adjacent pixel units can be effectively prevented and light leakage in the color conversion layer can be avoided.

In addition, the pixel unit in this embodiment further includes an enhanced common cathode. The enhanced common cathode and the common cathode are connected to enclose a first region and a second region separated from each other. The first compound light-emitting layer and the color conversion layer are stacked in the first region. The second compound light-emitting layer and the third compound light-emitting layer are stacked in the second region. The enhanced common cathode is arranged, so that electrical enhancement can be effectively performed and optical crosstalk between adjacent compound light-emitting layers can be effectively prevented. More importantly, light overflow in the first compound light-emitting layer can be effectively prevented.

In addition, the area of the projection of the color conversion layer on the backplane in this embodiment is larger than the area of the projection of the first compound light-emitting layer on the backplane, to avoid light overflow in the first compound light-emitting layer.

In addition, the red light quantum dot material is used in the color conversion layer in this embodiment, and the wavelength of the light source of the first compound semiconductor layer is less than that of red light. In this way, red light is implemented through color conversion, to avoid power consumption and performance defects caused by an external quantum effect due to a size effect in an AlGaInP red light system. Moreover, environmental protection problems caused by the GaAs red light system can be effectively solved, and reliability problems of high activity of green and blue light quantum dots under an ultra-large specific surface area are avoided.

In addition, according to the manufacturing method for a pixel unit for a semiconductor device in this embodiment, during device preparation, electrical connection of cathodes, and electrical connection of anodes, a damascene-like process is used for passivation and next-step bonding preparation. Compared with an existing solution of etching a metal layer to construct an electrical connection structure, this solution reduces the process difficulty in constructing an electrical connection in a stacking solution, and in particular, improves feasibility of using a metal (for example, copper) having difficult of being dry-etched as an electrical connection structure.

It should be noted that this embodiment only needs to achieve at least one of the foregoing technical effects.

### Embodiment 2

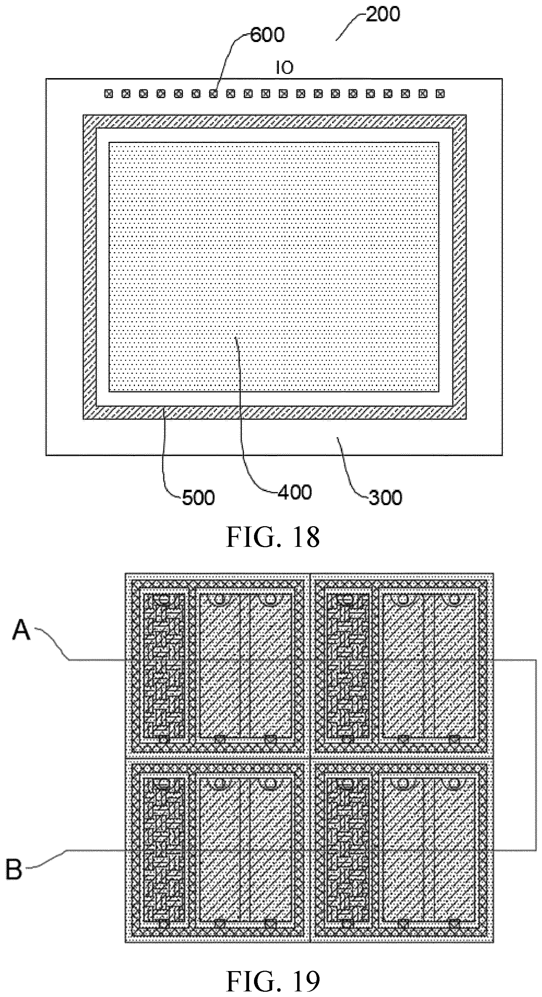

An embodiment provides a microdisplay 200. As shown in FIG. 18, the microdisplay 200 includes:
a drive backplane 300, where the drive backplane 300 includes at least two drive circuits, an input interface, and an output interface;
a display region 400, where the display region 400 is arranged on the drive backplane 300, the display region 400 includes at least two display units 20 as in Embodiment 1 and corresponding common cathodes 30, and the at least two display units 20 are arranged in an array;
a peripheral common cathode 500, where the peripheral common cathode 500 is electrically connected to the common cathode 30 of each of the display units 20 respectively, so that the entire microdisplay 200 has a common cathode, where it should be noted that the peripheral common cathode 500 is a metal surrounding frame structure surrounding the display region 400; and
an external IO interface 600, located at any position of the drive backplane 300.

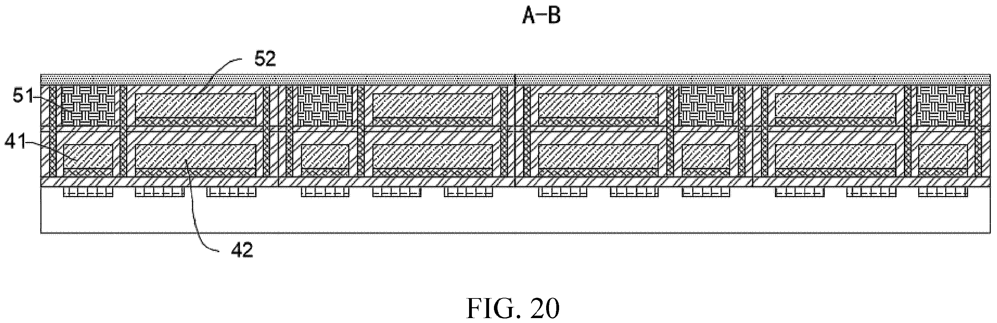

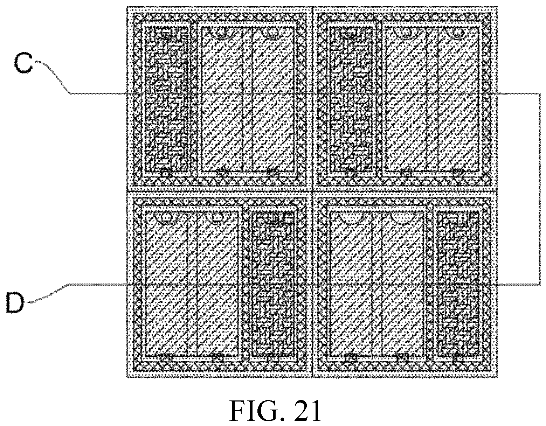

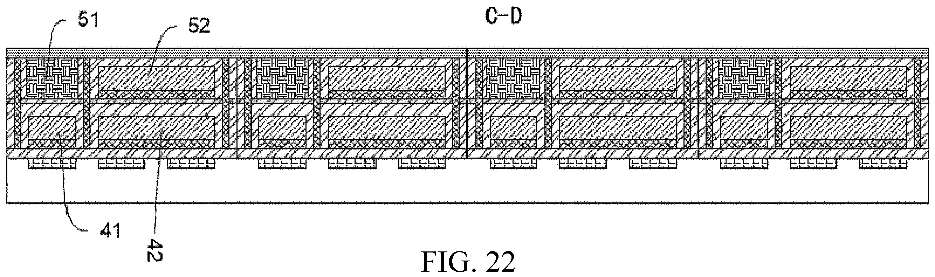

Further, an arrangement orientation of each of pixel units 100 adjacently arranged in an array in the microdisplay 200 is not limited in this embodiment. In an implementation, arrangement of four pixel units 100 is shown in FIG. 19 and FIG. 20. FIG. 20 is a cross-sectional view of a cross section A-B in FIG. 19. In another implementation, arrangement of the four pixel units 100 is shown in FIG. 21 and FIG. 22. FIG. 22 is a cross-sectional view of a cross section C-D in FIG. 21. Through adjustment of the arrangement orientation of the pixel unit 100, display edge jaggedness is improved or display is enhanced by borrowing adjacent pixels.

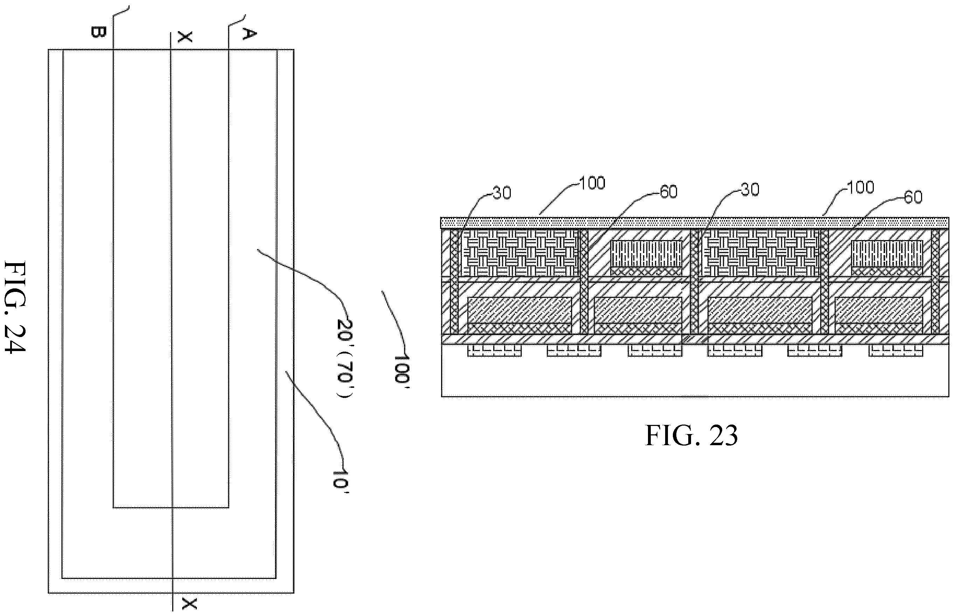

Moreover, to further increase a size of the pixel unit 100, the common cathodes 30 of adjacent pixel units 100 are merged and shared. For example, a cross-sectional diagram of two adjacent pixel units 100 is shown in FIG. 23 below.

For the specific structure of the microdisplay in this embodiment and the corresponding technical effects, refer to the related descriptions in Embodiment 1, and details are not further described in this embodiment.

### Embodiment 3

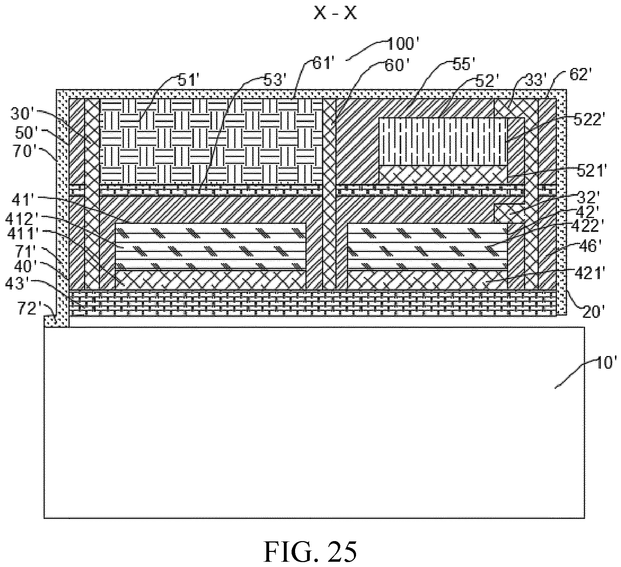

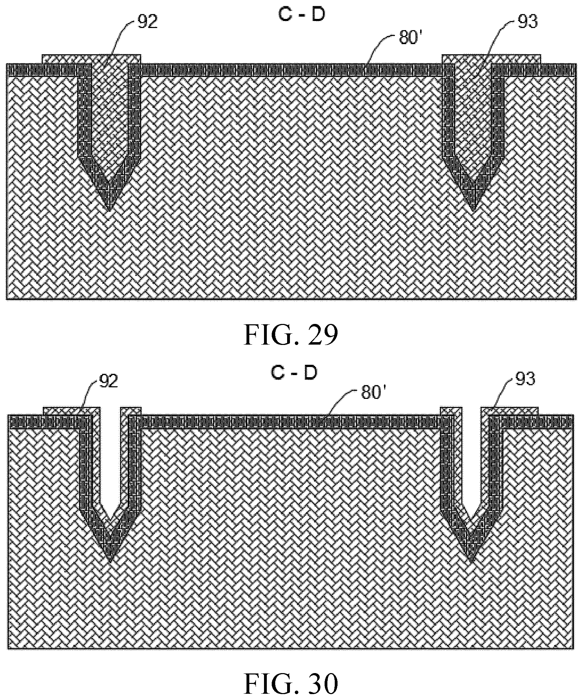

As shown in FIG. 24 to FIG. 30, an embodiment provides another pixel unit 100'. The pixel unit 100' includes a backplane 10', at least four pads, a display unit 20', a common cathode 30', an enhanced common cathode 60', and an isolation support structure 70'. The display unit 20' is arranged above the backplane 10', and the common cathode 30' is arranged around a periphery of the display unit 20', and is connected to any compound light-emitting layer in any device layer in the display unit 20'. The at least four pads are connected to the display unit 20', and at least part of each of the at least four pads is embedded in the backplane 10'. The display unit 20' is arranged separately from the backplane 10', and the isolation support structure 70' covers the display unit 20' and is connected to the backplane 10'. It should be noted that the structure of the display unit 20' in this embodiment is the same as the structure of the display unit 20 in Embodiment 1. The display unit 20' is not described in detail in this embodiment. For details, refer to the description of the display unit 20 in Embodiment 1. Details are not described again in this embodiment.

The following further describes the pixel unit 100' in detail with reference to the accompanying drawings.

A material of the backplane 10' is one of passive substrates such as silicon, PCB, sapphire, or glass. Alternatively, an SOI CMOS substrate that completes a switch controlling a single pixel circuit may be used. In this embodiment, a silicon-based backplane is used as an example for further detailed description.

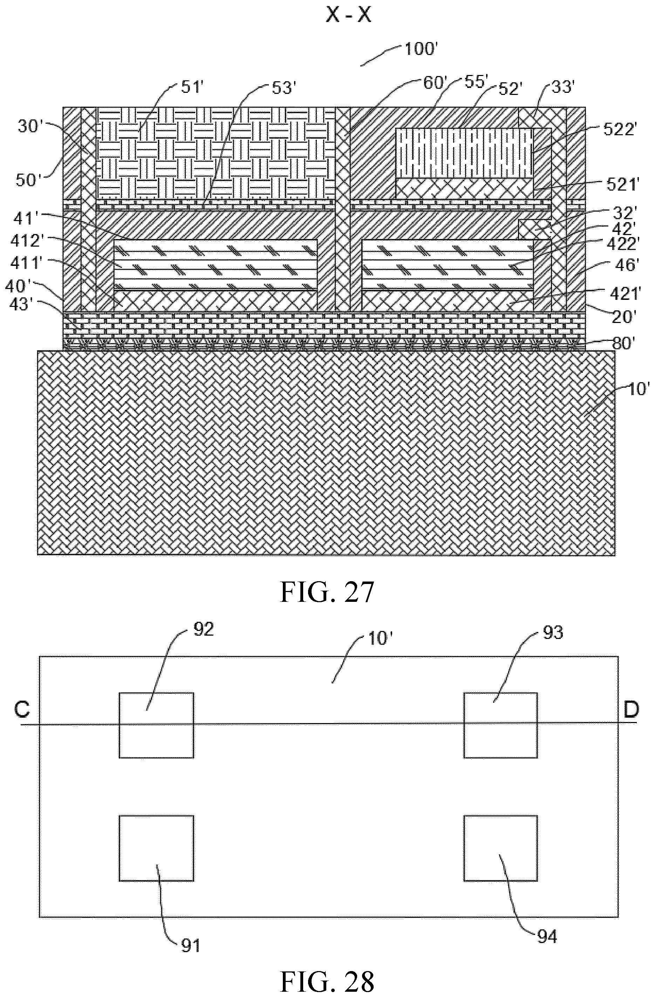

The pad is configured to match an electrical connection interface preset in a downstream package product. Therefore, a pad structure is not limited in this embodiment. In addition, to simplify the structure and reduce process difficulty, preferably, all pads have the same structure. The pad may be a solid structure or a hollow structure, as shown in FIG. 28 to FIG. 30.

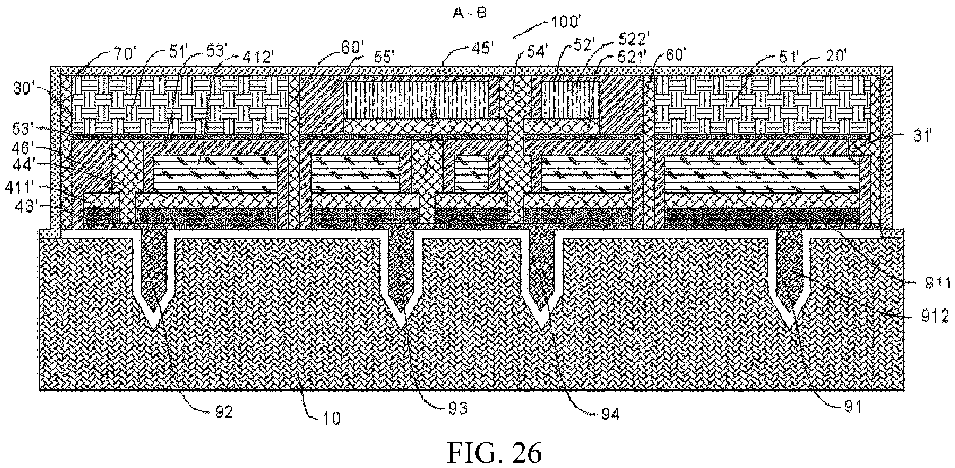

The at least four pads include one cathode pad 91 and at least three anode pads. Specifically, the cathode pad 91 is used as an example. As shown in FIG. 26, the cathode pad includes a first connection portion 911 and a needling portion 912 connected to each other. The first connection portion 911 is arranged outside the backplane 10' and is connected to the display unit 20'. The needling portion 912 is embedded in the backplane 10'. The needling portion 912 may be a cone structure, a step structure, a cylinder structure, a cuboid structure, or the like. In addition, an alloy or a stack of one or more of gold, titanium, tungsten, aluminum, or platinum may be used in the pad. Certainly, corresponding to the cathode pad 91 and the at least three anode pads, the backplane 10' is provided with at least four corresponding grooves, and the groove structure of the backplane 10' matches the corresponding pad structure. It should be further noted that, in this embodiment, the backplane 10' is arranged separately from any pad. In other words, there is no contact between the backplane 10' and any pad.

Still refer to FIG. 24 to FIG. 26. The display unit 20' includes a first device layer 40' and a second device layer 50' vertically stacked sequentially in a direction away from the backplane 10'. Further, the first device layer 40' includes a first compound light-emitting layer 41' and a second compound light-emitting layer 42' adjacent to each other. The second device layer 50' includes a color conversion layer 51' and a third compound light-emitting layer 52' adjacent to each other. The color conversion layer 51' is arranged above the first compound light-emitting layer 41'. In this way, the first device layer 40' serves as a backlight source of the color conversion layer 81. A light source line of the first compound light-emitting layer 41' passes through the color conversion layer 51' and is converted into a target light source line under the action of the color conversion material of the color conversion layer 51', thereby reducing power consumption of the target light source line and improving brightness.

Further, the at least three anode pads include a first anode pad 92, a second anode pad 93, and a third anode pad 94. Certainly, a quantity N of the anode pads is not less than a quantity of compound light-emitting layers in the device layer. The common cathode 30 is respectively connected to the cathode pad 91, the first compound light-emitting layer 41', the second compound light-emitting layer 42', and the third compound light-emitting layer 52', to implement connection between each compound light-emitting layer and the cathode pad 91.

Further, the first device layer 40' further includes a first bonding layer 43', a first anode electrical connection structure 44', a second anode electrical connection structure 45', and a first insulating wrapping layer 46'. The first bonding layer 43' is made of an insulating material. The first compound light-emitting layer 41' and the second compound light-emitting layer 42' are respectively attached onto a side of the first bonding layer 43' away from the backplane 10'. An end of the first anode electrical connection structure 44' is connected to the corresponding first anode pad 92, and an other end of the first anode electrical connection structure is connected to the first compound light-emitting layer 41'. An end of the second anode electrical connection structure 45' is connected to the corresponding second anode pad 93, and an other end of the second anode electrical connection structure is connected to the second compound light-emitting layer 42'.

The first compound light-emitting layer 41' includes a first P-type ohmic contact layer 411', a first compound semiconductor layer 412', and a first N-type ohmic contact layer (not shown in the figure) sequentially attached. It should be noted that the compound semiconductor layers in this embodiment are all quantum well compound semiconductor layers. The first P-type ohmic contact layer 411' is fittedly attached to the first bonding layer 43', and an area of the first P-type ohmic contact layer 411' is larger than an area of the first compound semiconductor layer 412'. Preferably, the first anode electrical connection structure 44' is arranged opposite to a side of the first compound semiconductor layer 412'. Part of the first anode electrical connection structure 44 passes through the first P-type ohmic contact layer 411' and the first bonding layer 43' sequentially and is connected to the first anode pad 92. A material of the first P-type ohmic contact layer 411' may be a transparent conductive material such as ITO, or may be a stack or an alloy of metal materials such as Au, Ni, Ag, and Mg. The first P-type ohmic contact layer 411' is formed by performing ITO coating on the first compound semiconductor layer 412' through evaporation, sputtering, or other methods. Preferably, a thickness of the ITO film is 500 nm, and ohmic contact is formed through high-temperature annealing at 500°C in an N₂ environment.

In addition, the common cathode 30' includes a first cathode electrical connection structure 31'. The first cathode electrical connection structure 31' is connected to the first N-type ohmic contact layer to implement connection between the first compound light-emitting layer 41' and the cathode pad 91.

Similarly, the second compound light-emitting layer 42' includes a second P-type ohmic contact layer 421', a second compound semiconductor layer 422', and a second N-type ohmic contact layer (not shown in the figure) sequentially attached. The second P-type ohmic contact layer 421' is fittedly attached to the first bonding layer 43', and an area of the second P-type ohmic contact layer 421' is larger than an area of the second compound semiconductor layer 422'. The second anode electrical connection structure 45' is arranged opposite to a side of the second compound semiconductor layer 422'. Part of the second anode electrical connection structure 45' passes through the second P-type ohmic contact layer 421' and the first bonding layer 43' sequentially and is connected to the corresponding second anode pad 93.

In this embodiment, the second anode electrical connection structure 45' is arranged opposite to a side of the second compound semiconductor layer 422', and the first anode electrical connection structure 44' is arranged opposite to a side of the first compound semiconductor layer 412', to avoid blocking of the light emitting surface by the electrical connection structures (the first anode electrical connection structure 74 and the second anode electrical connection structure 45').

In addition, the common cathode 30' further includes a second cathode electrical connection structure 32', and the second cathode electrical connection structure 32' is connected to the second N-type ohmic contact layer, to implement connection between the second compound light-emitting layer 42' and the cathode pad 91.

Further, the first insulating wrapping layer 46' is made of a transparent insulating material, for example, SiO₂. The first insulating wrapping layer 46' wraps the first compound light-emitting layer 41', the second compound light-emitting layer 42', the first anode electrical connection structure 44', the second anode electrical connection structure 45', and part of the common cathode 30'. The part of the common cathode 30' includes but is not limited to the first cathode electrical connection structure 31' and the second cathode electrical connection structure 32'.

In addition, the second device layer 50' further includes a second bonding layer 53', a third anode electrical connection structure 54', and a second insulating wrapping layer 55'. The second bonding layer 53' is made of a transparent insulating material, for example, SiO₂. The second bonding layer 53' is attached onto the first device layer 40', and the color conversion layer 51' and the third compound light-emitting layer 52' are respectively attached onto a side the second bonding layer 53' away from the first device layer 40'. In addition, an area of a projection of the color conversion layer 51' on the backplane 10' is larger than an area of a projection of the first compound light-emitting layer 41' on the backplane 10', effectively avoiding overflow of a light source line of the first compound light-emitting layer 41'.

Specifically, the second bonding layer 53' is made of a transparent insulating material, namely, silicon nitride. The third compound light-emitting layer 52' includes a third P-type ohmic contact layer 521', a third compound semiconductor layer 522', and a third N-type ohmic contact layer (not shown in the figure) sequentially attached. The third P-type ohmic contact layer 521' is fittedly attached to the second bonding layer 53', and an area of the third P-type ohmic contact layer 521' is larger than an area of the third compound semiconductor layer 522'. The third anode electrical connection structure 54' is arranged opposite to a side of the third compound semiconductor layer 522'. Part of the third anode electrical connection structure 54' passes through the third P-type ohmic contact layer 521', the second bonding layer 53', and the first bonding layer 43' sequentially and is connected to the corresponding third anode pad 94. Similarly, the common cathode 30' includes a third cathode electrical connection structure 33', and the third cathode electrical connection structure 33' is connected to the third N-type ohmic contact layer, to implement connection between the third compound light-emitting layer 52' and the cathode pad 91. The second insulating wrapping layer 55' wraps the color conversion layer 51', the third compound light-emitting layer 52', the third anode electrical connection structure 54', and part of the common cathode 30'. The part of the common cathode 30' includes but is not limited to, the third cathode electrical connection structure 33'. The second insulating wrapping layer 55 is made of a transparent insulating material, for example, SiO₂.

It should be noted that all the anode electrical connection structures and the common cathode 30' are made of metal materials, such as Cu and Al.

The enhanced common cathode 60' and the common cathode 30' are connected to enclose at least two regions separated from each other. Each region includes at least one compound light-emitting layer or a color conversion layer 51'. A material of the enhanced common cathode 60' is a metal such as Cu or Al, and is a good conductor. In this embodiment, the enhanced common cathode 60' and the common cathode 30 are connected to enclose a first region 61' and a second region 62' separated from each other. Part of the enhanced common cathode 60' is arranged through and between the third compound light-emitting layer 52' and the color conversion layer 51', and part of the enhanced common cathode 60' is arranged through and between the first compound light-emitting layer 41' and the second compound light-emitting layer 42'. The first compound light-emitting layer 41' and the color conversion layer 51' are stacked in the first region 61', and the second compound light-emitting layer 42' and the third compound light-emitting layer 52' are stacked in the second region 62'.

Further, as shown in FIG. 24 to FIG. 26, the isolation support structure 70' includes a covering portion 71' and a fixing portion 72' connected to each other. The covering portion 71' covers the display unit 20'. The fixing portion 72' is connected to the backplane 10'. The isolation support structure 70' forms a tether structure to fixedly connect the display unit 20' to the backplane 10'.

Specifically, the covering portion 71' covers the display unit 20', and is mainly configured to implement water vapor isolation to prevent the color conversion layer 51' from being eroded by water vapor to affect performance and life. The covering portion 71' is made of a transparent dielectric material. The transparent dielectric material includes a single layer or a stack of an inorganic dielectric material such as silicon oxide, silicon nitride, aluminum oxide, titanium oxide, or diamond, or may be an organic dielectric material such as SU8 or polyimide, or may be a polycrystalline material such as glass or soda. Preferably, the covering portion 71' is a Bragg reflection layer formed by a stack of silicon oxide and titanium oxide. The covering portion 71' on the surface of the third compound light-emitting layer 52' is removed by etching. The covering portion 71' can function as a light filter, allowing only a red light band to be transmitted.

In addition, as shown in FIG. 27, the display unit 20' is arranged separately from the backplane 10', and the at least four pads are arranged separately from the backplane 10'. The separation arrangement may be implemented by pre-arranging a sacrificial layer 80' between the backplane 10' and the at least four pads in a manufacturing process, and removing the sacrificial layer 80' through etching or other methods after device stacking is completed and the isolation support structure 70' is formed. Therefore, during transfer of the pixel unit 100', it is only necessary to break the covering portion 71' and the fixing portion 72' by an external force, which is convenient to use. In addition, in this structure, the backplane 10' can be recycled, thereby reducing costs.

In an exemplary structure, the part of the isolation support structure 70' covering the backplane 10' is fittedly attached onto the backplane 10', and an edge of the part may be flush with, extending beyond, or retracted from a corresponding edge of the backplane 10'. This is not limited in this embodiment.

Corresponding to the foregoing pixel unit 100', an embodiment further provides a manufacturing method for a pixel unit, including the following steps:
S1': Prepare a backplane.
Specifically, step S1' includes:
   S11': Etch a pre-prepared backplane to form at least four cavities.
   S12': Plate a sacrificial layer on a side of the backplane provided with the at least four cavities, where the sacrificial layer is formed by performing coating, thermal oxidation, wet oxidation, or the like on the surface of the backplane by using a silicon oxynitride film.
   S13': Construct at least four pads on the side of the backplane plated with the sacrificial layer, where part of a structure of each of the pads is embedded in the corresponding cavity, and the at least four pads include one cathode pad and at least three anode pads.

The pad in this embodiment is a metal pad, and may be an alloy or a stack of one or more of gold, titanium, tungsten, aluminum, or platinum. A preparation manner includes thermal evaporation, sputtering, electroplating, chemical plating, or the like. The pad may be solid or hollow.

S2': Bond a pre-prepared first target compound semiconductor to the backplane to form a first bonding layer, construct a first compound light-emitting layer and a second compound light-emitting layer adjacent to each other to form a first device layer, bond a pre-prepared second target compound semiconductor to a side of the first device layer away from the backplane to form a second bonding layer, and construct a third compound light-emitting layer and a color conversion layer adjacent to the third compound light-emitting layer to form a second device layer, where the color conversion layer is arranged above the first compound light-emitting layer.

The at least four pads include a first anode pad, a second anode pad, and a third anode pad. Specifically, step S2' includes:
S21': Bond a pre-prepared first target compound semiconductor to the backplane, and construct a first compound light-emitting layer and a second compound light-emitting layer adjacent to each other to form a first device layer, including:
S211': Plate an entire surface of the backplane on which the at least four pads are arranged with an insulating material, and provide at least one through hole corresponding to any pad.
S212': Manufacture a first P-type ohmic contact layer on a surface of the first target compound semiconductor, and plating an entire surface of the first P-type ohmic contact layer with an insulating material.

Preferably, an InGaN ternary compound is used in the first target compound semiconductor. Therefore, before step S212, the manufacturing method further requires pre-preparation of the first target compound semiconductor. For details, refer to the description in Embodiment 1.

S213': Bond the backplane to the first target compound semiconductor.

S214': Remove a substrate of the first target compound semiconductor to expose an N-type ohmic contact layer of the first target compound semiconductor.

S215': Perform patterned etching on the first target compound semiconductor exposing the N-type ohmic contact layer to form the first compound light-emitting layer and the second compound light-emitting layer adjacent to each other, etch part of the first compound light-emitting layer to the first P-type ohmic contact layer, and etch part of the second compound light-emitting layer to the second P-type ohmic contact layer. **In** this way, the first compound light-emitting layer and the second compound light-emitting layer adjacent to each other are formed, where the first compound light-emitting layer includes the first P-type ohmic contact layer, the first compound semiconductor layer, and the first N-type ohmic contact layer fittedly attached sequentially, and the second compound light-emitting layer includes the second **P-**type ohmic contact layer, the second compound semiconductor layer, and the second N-type ohmic contact layer fittedly attached sequentially.

S216': Wrap entire surfaces of the first compound light-emitting layer and the second compound light-emitting layer to form a first insulating wrapping layer. For example, the surfaces of the first compound light-emitting layer and the second compound light-emitting layer are plated with SiO₂ by using an atomic layer deposition (ALD) process to form the first insulating wrapping layer.

S217': Perform patterned etching on the first insulating wrapping layer to respectively form a first anode electrical connection channel, a second anode electrical connection channel, a first cathode electrical connection channel, and a second cathode electrical connection channel.

S218': Perform metal coating on the first insulating wrapping layer to respectively form a first anode electrical connection structure connected to the first anode pad, a second anode electrical connection structure connected to the second anode pad, a first cathode electrical connection structure, and a second cathode electrical connection structure.

S22': Construct a third compound light-emitting layer and perform filling to form a color conversion layer adjacent to the third compound light-emitting layer, including:
S221': Perform patterned etching on the second target compound semiconductor exposing an N-type ohmic contact layer to form the third compound light-emitting layer, and etch part of the third compound light-emitting layer to the third P-type ohmic contact layer. The second target compound semiconductor in this embodiment is a silicon-based green light compound epitaxial layer, and for a structure thereof, refer to the description in S212. In this way, the third compound light-emitting layer is formed. The first compound light-emitting layer includes the third P-type ohmic contact layer, the third compound semiconductor layer, and the third N-type ohmic contact layer fittedly attached sequentially.
S222': Wrap an entire surface on which the third compound light-emitting layer is located by using a transparent insulating material to form a second insulating wrapping layer.
S223': Perform patterned etching on the second insulating wrapping layer, the second bonding layer, the first insulating wrapping layer, and the first bonding layer to respectively form a third anode electrical connection channel, a third cathode electrical connection channel, and a first slot.
S224': Fill the first slot with a color conversion material to form the color conversion layer, where the color conversion layer is attached onto the second bonding layer. Specifically, the first slot is filled with the color conversion material through spray printing, spin coating, patterning, or imprinting, and then the color conversion material is planarized through CMP planarization or scraper blading.
S225': Perform metal coating on a surface on which the second insulating wrapping layer is located to respectively form a third anode electrical connection structure connected to the third anode pad and a third cathode electrical connection structure, to form the second device layer.

In a preferred implementation, after step S2' is completed, step S3' is further included: constructing an enhanced common cathode, including:
S31': Perform patterned etching on the second device layer and the first device layer to form an enhanced common cathode channel, part of the enhanced common cathode channel is arranged through and between the third compound light-emitting layer and the color conversion layer, and part of the enhanced common cathode channel is arranged through and between the first compound light-emitting layer and the second compound light-emitting layer.
S32': Perform metal coating on a surface of the second device layer to form an enhanced common cathode, where the enhanced common cathode and a common cathode are connected to enclose a first region and a second region separated from each other.

After step S2' or S3' is completed, the manufacturing method further includes step S4': forming an isolation support structure, including:
S41': Plate a dielectric material on a surface of a display unit and extend the dielectric material to part of a surface of the backplane to form the isolation support structure. The isolation support structure includes a covering portion and a fixing portion connected to each other. The covering portion covers the display unit. The fixing portion is connected to the backplane.

Specifically, Al₂O₃ coating is performed on the surface of the second device layer and part of the surface of the backplane by using the ALD process, to form the covering portion for water vapor isolation, thereby enhancing stability of the color conversion material. In addition, the fixed connection between the display unit and the backplane is completed.

S42': Etch the sacrificial layer on a side surface of the backplane not plated with the dielectric material, to separate the at least four pads from the backplane, where a ratio of an etching rate of the sacrificial layer to an etching rate of the backplane is greater than 10:1, and a ratio of the etching rate of the sacrificial layer to an etching rate of the isolation support structure is greater than 10:1. In addition, preferably, a gap between the backplane and the display unit after the etching ranges from 100 nm to 1000 nm, preferably 300 nm to 500 nm.

In conclusion, in this embodiment, at least two vertically stacked device layers are arranged on the backplane, to reduce the size and the quantity of pixel-level discrete devices in the horizontal direction. The loss of the pixel density is avoided, and a quantity of transferred chips during mass transfer is reduced, thereby improving precision and the yield. A quantity of times of mass transfer is reduced, thereby reducing costs. In addition, the color conversion layer is arranged, so that the compound light-emitting layer whose external quantum efficiency is greatly decreased due to the size effect can implement color development through color conversion, to implement full-color display while reducing power and improving performance.

In addition, the common cathode is arranged in this embodiment, to reduce an area proportion of the cathode in the display unit, improve an area proportion of a light-emitting region, and reduce impact of the size effect. In addition, a quantity of stacked device layers in the vertical direction can be increased or redundant circuits can be formed, and optical crosstalk between adjacent pixels can be effectively prevented and light leakage in the color conversion layer can be avoided.

In addition, the pixel unit in this embodiment is connected to an external circuit based on at least four pads. The discrete device is packaged to a target backplane through the pads for electrical connection, to simplify the process, and avoid soldering of a metal such as eutectic, to avoid affecting performance of the pixel-level discrete device.

Moreover, in this embodiment, the display unit is arranged separately from the backplane, and the at least four pads are arranged separately from the backplane. The pixel-level discrete device further includes the isolation support structure. The isolation support structure covers the display unit and part of the backplane. The pixel-level discrete device is provided with the isolation support structure to protect the color conversion from being eroded by water vapor to affect performance, and improve structural stability when the display unit is arranged separately from the backplane and convenience for subsequent use. In addition, in this structure, the backplane can be recycled, thereby reducing costs.

In addition, the pixel unit in this embodiment further includes an enhanced common cathode. The enhanced common cathode and the common cathode are connected to enclose a first region and a second region separated from each other. The first compound light-emitting layer and the color conversion layer are stacked in the first region. The second compound light-emitting layer and the third compound light-emitting layer are stacked in the second region. The enhanced common cathode is arranged, so that electrical enhancement can be effectively performed and optical crosstalk between adjacent compound light-emitting layers can be effectively prevented. More importantly, light overflow in the first compound light-emitting layer can be effectively prevented.

In addition, the red light quantum dot material is used in the color conversion layer in this embodiment, and the wavelength of the light source of the first compound semiconductor layer is less than that of red light. In this way, red light is implemented through color conversion, to avoid power consumption and performance defects caused by an external quantum effect due to a size effect in an AlGaInP red light system. Moreover, environmental protection problems caused by the original GaAs red light system can be effectively solved, and reliability problems of high activity of green and blue light quantum dots under an ultra-large specific surface area are avoided.

It should be noted that this embodiment only needs to achieve at least one of the foregoing technical effects.

### Embodiment 4

This embodiment provides a pixel-level discrete device. The pixel-level discrete device includes:
a discrete device backplane, where the discrete device backplane includes at least three anode pads and at least one cathode pad; and
a device body, where the device body is arranged on the discrete device backplane, and the device body includes at least two display units included in the pixel unit according to Embodiment 3, or at least two display units included in the pixel unit manufactured by using the manufacturing method according to Embodiment 3.

All the foregoing optional technical solutions may be arbitrarily combined to form an optional embodiment of this application. In other words, any number of embodiments may be combined to meet the needs of different application scenarios, which are all within the scope of protection of this application. Details are not described herein again.

It should be noted that the foregoing descriptions are merely exemplary embodiments of this application, and are not intended to limit this application. Any modification, equivalent replacement, improvement and the like made within the spirit and principle of this application shall fall within the protection scope of this application.

## Claims

1. A pixel unit for a semiconductor device, the pixel unit comprising:
a backplane; and
a display unit, wherein the display unit is arranged on the backplane, the display unit comprises a first device layer and a second device layer vertically stacked sequentially in a direction away from the backplane, the first device layer comprises a first compound light-emitting layer and a second compound light-emitting layer adjacent to each other, the second device layer comprises a color conversion layer and a third compound light-emitting layer adjacent to each other, and the color conversion layer is arranged above the first compound light-emitting layer.

2. The pixel unit according to claim 1, wherein the pixel unit further comprises a common cathode, the common cathode is arranged around a periphery of the display unit, the common cathode is respectively connected to the first compound light-emitting layer, the second compound light-emitting layer, and the third compound light-emitting layer, and the common cathode is connected to an external cathode.

3. The pixel unit according to claim 2, wherein the pixel unit further comprises an enhanced common cathode, the enhanced common cathode and the common cathode are connected to enclose a first region and a second region separated from each other, the first compound light-emitting layer and the color conversion layer are stacked in the first region, and the second compound light-emitting layer and the third compound light-emitting layer are stacked in the second region.

4. The pixel unit according to claim 2, wherein the first device layer further comprises a first bonding layer, and the first bonding layer is made of an insulating material; and
the first bonding layer is attached onto the backplane, and the first compound light-emitting layer and the second compound light-emitting layer are respectively attached onto a side of the first bonding layer away from the backplane.

5. The pixel unit according to claim 4, wherein the first device layer further comprises a first anode electrical connection structure and a second anode electrical connection structure;
an end of the first anode electrical connection structure is connected to the first compound light-emitting layer, and an other end of the first anode electrical connection structure extends toward the backplane; and
an end of the second anode electrical connection structure is connected to the second compound light-emitting layer, and an other end of the second anode electrical connection structure extends toward the backplane.

6. The pixel unit according to claim 5, wherein the first compound light-emitting layer comprises a first P-type ohmic contact layer, a first compound semiconductor layer, and a first N-type ohmic contact layer sequentially attached, the first P-type ohmic contact layer is fittedly attached to the first bonding layer, and an area of the first P-type ohmic contact layer is larger than an area of the first compound semiconductor layer;
the first anode electrical connection structure is arranged opposite to a side of the first compound semiconductor layer, and part of the first anode electrical connection structure passes through the first P-type ohmic contact layer and the first bonding layer sequentially;

7. The pixel unit according to claim 6, wherein the common cathode comprises a first cathode electrical connection structure, and the first cathode electrical connection structure is connected to the first N-type ohmic contact layer.

8. The pixel unit according to claim 5, wherein the second device layer further comprises a second bonding layer, and the second bonding layer is made of a transparent insulating material;
the second bonding layer is attached onto the first device layer, and the color conversion layer and the third compound light-emitting layer are respectively attached onto a side of the second bonding layer away from the first device layer.

9. The pixel unit according to claim 8, wherein the color conversion layer is attached onto the second bonding layer, and an area of a projection of the color conversion layer on the backplane is larger than an area of a projection of the first compound light-emitting layer on the backplane.

10. The pixel unit according to claim 9, wherein the photochromic material is used in the color conversion layer, and a wavelength of a light source of the first compound semiconductor layer is less than a wavelength of light of the color conversion layer.

11. The pixel unit according to claim 10, wherein at least one of a red light quantum dot material or a red phosphor material is used in the color conversion layer.

12. The pixel unit according to claim 8, wherein the second device layer further comprises a third anode electrical connection structure, the third anode electrical connection structure is arranged opposite to a side of the third compound semiconductor layer, an end of the third anode electrical connection structure is connected to the third compound light-emitting layer, and an other end of the third anode electrical connection structure extends toward the backplane.

13. The pixel unit according to claim 12, wherein the display unit further comprises a first insulating wrapping layer and a second insulating wrapping layer, and both the first insulating wrapping layer and the second insulating wrapping layer are made of a transparent insulating material;
the first insulating wrapping layer wraps the first compound light-emitting layer, the second compound light-emitting layer, the first anode electrical connection structure, the second anode electrical connection structure, part of the third anode electrical connection structure, and part of the common cathode; and
the second insulating wrapping layer wraps the color conversion layer, the third compound light-emitting layer, part of the third anode electrical connection structure, and part of the common cathode.

14. The pixel unit according to claim 12 or 13, wherein the backplane is provided with a drive circuit, the drive circuit is provided with at least one anode, and the at least one anode comprises a first anode, a second anode, and a third anode; and
the first anode electrical connection structure is connected to the first anode, the second anode electrical connection structure is connected to the second anode, and the third anode electrical connection structure is connected to the third anode.

15. The pixel unit according to any one of claims 1 to 14, wherein the display unit further comprises a water vapor isolation layer arranged on a surface of the second device layer.

16. The pixel unit according to claim 12 or 13, wherein the pixel unit further comprises at least four pads, the at least four pads comprise a cathode pad and at least three anode pads, and at least part of any one of the at least four pads is embedded in the backplane;
the common cathode is connected to the cathode pad; and
the first anode electrical connection structure, the second anode electrical connection structure, and the third anode electrical connection structure are respectively connected to corresponding anode pads among the at least three anode pads.

17. The pixel unit according to claim 16, wherein thedevice body is arranged separately from the backplane, and the at least four pads are arranged separately from the backplane; and
the pixel-level discrete device further comprises an isolation support structure, and the isolation support structure covers the device body and is connected to the backplane.

18. The pixel unit according to claim 16, wherein the isolation support structure comprises a covering portion and a fixing portion connected to each other, the covering portion covers the device body, and the fixing portion is connected to the backplane.

19. A manufacturing method for the pixel unit according to any one of claims 1 to 15, the manufacturing method comprising:
preparing a backplane; and
manufacturing a display unit, bonding a pre-prepared first target compound semiconductor to the backplane to form a first bonding layer, constructing a first compound light-emitting layer and a second compound light-emitting layer adjacent to each other to form a first device layer, bonding a pre-prepared second target compound semiconductor to a side of the first device layer away from the backplane to form a second bonding layer, and constructing a third compound light-emitting layer and a color conversion layer adjacent to the third compound light-emitting layer to form a second device layer, wherein the color conversion layer is arranged above the first compound light-emitting layer.

20. The manufacturing method according to claim 19, wherein the bonding a pre-prepared first target compound semiconductor to the backplane comprises:
plating an entire surface of the backplane on which at least one anode is arranged with an insulating material, and providing at least one through hole corresponding to the at least one anode;
manufacturing a first P-type ohmic contact layer on a surface of the first target compound semiconductor, and plating an entire surface of the first P-type ohmic contact layer with an insulating material;
bonding the backplane to the first target compound semiconductor; and
removing a substrate of the first target compound semiconductor to expose an N-type ohmic contact layer of the first target compound semiconductor.

21. The manufacturing method according to claim 20, wherein the constructing a first compound light-emitting layer and a second compound light-emitting layer adjacent to each other to form a first device layer comprises:
performing patterned etching on the first target compound semiconductor exposing the N-type ohmic contact layer to form the first compound light-emitting layer and the second compound light-emitting layer adjacent to each other;
wrapping entire surfaces of the first compound light-emitting layer and the second compound light-emitting layer to form a first insulating wrapping layer;
performing patterned etching on the first insulating wrapping layer to respectively form a first anode electrical connection channel, a second anode electrical connection channel, a first cathode electrical connection channel, and a second cathode electrical connection channel; and
performing metal coating on a surface of the first insulating wrapping layer to respectively form a first anode electrical connection structure, a second anode electrical connection structure, a first cathode electrical connection structure, and a second cathode electrical connection structure.

22. The manufacturing method according to claim 23, wherein the constructing a third compound light-emitting layer and performing filling to form a color conversion layer adjacent to the third compound light-emitting layer comprises:
performing patterned etching on the second target compound semiconductor exposing an N-type ohmic contact layer to form the third compound light-emitting layer;
wrapping an entire surface on which the third compound light-emitting layer is located to form a second insulating wrapping layer;
performing patterned etching on the second insulating wrapping layer, the second bonding layer, the first insulating wrapping layer, and the first bonding layer to respectively form a third anode electrical connection channel, a third cathode electrical connection channel, and a first slot;
filling the first slot with a color conversion material to form the color conversion layer, wherein the color conversion layer is attached onto the second bonding layer; and
performing metal coating on a surface on which the second insulating wrapping layer is located to respectively form a third anode electrical connection structure connected to a third anode and a third cathode electrical connection structure connected to a cathode, to form the second device layer.

23. The manufacturing method according to any one of claims 19 to 22, wherein after the second device layer is constructed, the manufacturing method further comprises:
performing patterned etching on the second device layer and the first device layer to form an enhanced common cathode channel, part of the enhanced common cathode channel is arranged through and between the third compound light-emitting layer and the color conversion layer, and part of the enhanced common cathode channel is arranged through and between the first compound light-emitting layer and the second compound light-emitting layer; and
performing metal coating on a surface of the second device layer to form the enhanced common cathode, wherein the enhanced common cathode and the common cathode are connected to enclose a first region and a second region separated from each other.

24. The manufacturing method according to claim 23, wherein after the second device layer is constructed, the manufacturing method further comprises:
plating a water vapor isolation material on the surface of the second device layer to form a water vapor isolation layer.

25. A manufacturing method for the pixel unit according to any one of claims 1 to 12, or 16 to 18, wherein the manufacturing method comprises:
preparing a backplane; and
bonding a pre-prepared first target compound semiconductor to the backplane, constructing a first compound light-emitting layer and a second compound light-emitting layer adjacent to each other to form a first device layer, bonding a pre-prepared second target compound semiconductor to a side of the first device layer away from the backplane, and constructing a third compound light-emitting layer and a color conversion layer adjacent to the third compound light-emitting layer to form a second device layer, wherein the color conversion layer is arranged above the first compound light-emitting layer.

26. The manufacturing method according to claim 25, wherein the preparing a backplane comprises:
etching the pre-prepared backplane to form at least four cavities;
plating a sacrificial layer on a side of the backplane provided with the at least four cavities; and
constructing at least four pads on the side of the backplane plated with the sacrificial layer, wherein part of each of the pads is embedded in the corresponding cavity, and the at least four pads comprise one cathode pad and at least three anode pads.

27. The manufacturing method according to claim 25, wherein after the second device layer is constructed, the manufacturing method further comprises forming an isolation support structure, comprising:
plating a dielectric material on a surface of the device body and extending the dielectric material to part of a surface of the backplane to form the isolation support structure; and
etching the sacrificial layer on a side surface of the backplane not plated with the dielectric material, to separate the at least four pads from the backplane, wherein a ratio of an etching rate of the sacrificial layer to an etching rate of the backplane is greater than 10: 1, and a ratio of the etching rate of the sacrificial layer to an etching rate of the isolation support structure is greater than 10: 1.

28. A microdisplay, comprising:
a microdisplay backplane, wherein the microdisplay backplane comprises a drive circuit, an input interface, and an output interface;
a display region, wherein the display region is arranged on the microdisplay backplane, the display region comprises at least two display units comprised in the pixel unit according to any one of claims 1 to 15 or at least two display units comprised in the pixel unit manufactured by using the manufacturing method for a pixel unit according to any one of claims 19 to 24, and the at least two display units are arranged in an array; and
a peripheral common cathode, wherein the peripheral common cathode is electrically connected to a common cathode of each of the display units respectively.

29. A pixel-level discrete device, the pixel-level discrete device comprising:
a discrete device backplane, wherein the discrete device backplane comprises at least three anode pads and at least one cathode pad; and
a device body, wherein the device body is arranged on the discrete device backplane, and the device body comprises at least two display units comprised in the pixel unit according to any one of claims 1 to 12, or 16 to 18, or at least two display units comprised in the pixel unit manufactured by using the manufacturing method according to any one of claims 25 to 27.
